# EUROPEAN PATENT SPECIFICATION

(11) **EP 4 386 726 B1**
(45) Date of publication and mention of the grant of the patent: **19.08.2026**
(21) Application number: 22863904.3
(22) Date of filing: 18.03.2022
(51) Int. Cl.: H10H 29/32, H10H 29/49, H10H 29/80

(54) **LIGHT-EMITTING DEVICE AND ELECTRONIC EQUIPMENT**
LICHTEMITTIERENDE VORRICHTUNG UND ELEKTRONISCHES GERÄT
DISPOSITIF D'ÉMISSION DE LUMIÈRE ET ÉQUIPEMENT ÉLECTRONIQUE

(30) Priority: 03.09.2021 JP 2021144131
(43) Date of publication of application: 19.06.2024
(73) Proprietor: Sony Group Corporation, Tokyo 108-0075 (JP)
(72) Inventor: KANEMITSU, Toshiaki, Tokyo 108-0075 (JP); HIRAO, Naoki, Tokyo 108-0075 (JP); BIWA, Goshi, Tokyo 108-0075 (JP); DOI, Masato, Tokyo 108-0075 (JP); OHMAE, Akira, Tokyo 108-0075 (JP)
(74) Representative: D Young & Co LLP
(86) International application number: PCT/JP2022/012796
(87) International publication number: WO 2023/032314

(56) References cited:
- EP-A1- 2 980 866
- WO-A1-2008/007535
- WO-A1-2020/263183
- WO-A1-2021/115472
- CN-A- 111 540 764
- US-A1- 2014 367 708
- US-A1- 2019 165 207
- US-A1- 2019 198 565
- US-A1- 2020 066 696
- US-A1- 2020 111 767
- US-A1- 2020 258 872
- US-A1- 2020 403 026

## Description

### TECHNICAL FIELD

The present invention relates to a light emitting device and an electronic apparatus including the same.

### BACKGROUND ART

In recent years, a light emitting device including a plurality of semiconductor light emitting elements is widely known. As such a light emitting device, one having a configuration in which semiconductor light emitting elements of a plurality of colors are laminated has been proposed (see, for example, Patent Document 1).

### CITATION LIST

WO 2018/156876 A1, US 2019/198565 A1, US 2019/165207 A1, US 2020/403026 A1, EP 2980866 A1 and US 2020/111767 A1 disclose a light emitting device comprising a plurality of layers stacked on a substrate and each including a plurality of semiconductor light emitting elements.

### SUMMARY OF THE INVENTION

### PROBLEMS TO BE SOLVED BY THE INVENTION

However, in the light emitting device in which the semiconductor light emitting elements of the plurality of colors are laminated, light of the semiconductor light emitting element on a lower layer is hindered by the semiconductor light emitting element on an upper layer, and there is a case where luminance is reduced.

An object of the present invention is to provide a light emitting device that can suppress decrease in luminance and an electronic apparatus including the same.

### SOLUTIONS TO PROBLEMS

The present invention is defined by the claims.

### BRIEF DESCRIPTION OF DRAWINGS

Fig. 1 is a plan view illustrating a configuration of a display device according to an example not forming part of the present invention.
Fig. 2A is a plan view illustrating a configuration of a pixel according to an example not forming the present invention. Fig. 2B is a transparent view of the pixel when viewed from the direction of an arrow 102A in Fig. 2A.
Fig. 3 is a plan view illustrating an example of a configuration of a first layer.
Fig. 4 is a plan view illustrating an example of a configuration of a second layer.
Fig. 5A is a cross-sectional view illustrating an example of a configuration of a first compound semiconductor light emitting element. Fig. 5B is a cross-sectional view illustrating an example of a configuration of a second compound semiconductor light emitting element. Fig. 5C is a cross-sectional view illustrating an example of a configuration of a third compound semiconductor light emitting element.
Fig. 6 is a cross-sectional view illustrating an example of a configuration of the first compound semiconductor light emitting element.
Fig. 7 is a diagram for explaining an example of a total sum S_{RGB} of an area S_{R} of the first compound semiconductor light emitting element, an area S_{G} of the second compound semiconductor light emitting element, and an area S_{B} of the third compound semiconductor light emitting element, and an area S_{PIX} of one pixel.
Fig. 8 is a plan view illustrating an example of a configuration of a display device according to an embodiment of the present invention.
Fig. 9A is a plan view illustrating an example of a configuration of a pixel. Fig. 9B is a transparent view of the pixel when viewed from the direction of an arrow 202A in Fig. 9A.
Fig. 10 is a cross-sectional view illustrating an example of a configuration of a fourth compound semiconductor light emitting element.
Figs. 11A and 11B are cross-sectional views each illustrating a modification of the first compound semiconductor light emitting element.
Fig. 12 is a plan view illustrating a modification of the first compound semiconductor light emitting element.
Fig. 13 is a plan view illustrating a modification of the first compound semiconductor light emitting element.
Fig. 14 is a plan view illustrating a modification of the first compound semiconductor light emitting element, the second compound semiconductor light emitting element, and the third compound semiconductor light emitting element.
Fig. 15 is a plan view illustrating a modification of the first compound semiconductor light emitting element, the second compound semiconductor light emitting element, and the third compound semiconductor light emitting element.
Figs. 16A and 16B are plan views each for explaining a modification of the second compound semiconductor light emitting element.
Fig. 17A is a front view illustrating an example of an external appearance of a digital still camera. Fig. 17B is a rear view illustrating an example of an external appearance of the digital still camera.
Fig. 18 is a perspective view illustrating an example of an external appearance of a head mounted display.
Fig. 19 is a perspective view illustrating an example of an external appearance of a television apparatus.

### MODE FOR CARRYING OUT THE INVENTION

Embodiments of the present disclosure are described in the following order.
1 Example of display device not forming part of the present invention.
2 Embodiment of display device according to the present invention.
3 Modifications (Modification of display device)
4 Application Example (Example of electronic apparatus)

### <1 Example>

### [Configuration of display device]

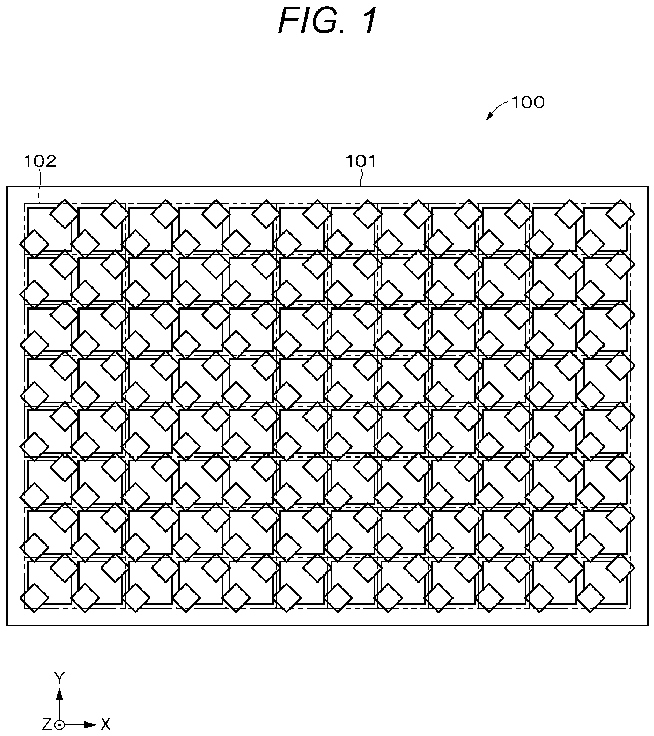

Fig. 1 is a plan view illustrating a configuration of a display device 100 according to an example not forming part of the present invention. The display device 100 includes a drive substrate 101 and a plurality of pixels 102. The plurality of pixels 102 is two-dimensionally arranged on a first surface of the drive substrate 101, in a prescribed arrangement pattern such as a matrix shape. The display device 100 is, for example, a light emitting diode (LED). The display device 100 is an example of a light emitting device.

In the following description, in each layer and each member included in the display device 10, a surface on the display surface side of the display device 10 is referred to as a first surface, and a surface on the opposite side to the above display surface is referred to as a second surface. A first direction (horizontal direction) and a second direction (vertical direction) orthogonal to each other in the first surface of the drive substrate 101 are referred to as an X-axis direction and a Y-axis direction, respectively, and a direction perpendicular to the first surface of the drive substrate 101 is referred to as a Z-axis direction.

### (Drive substrate 101)

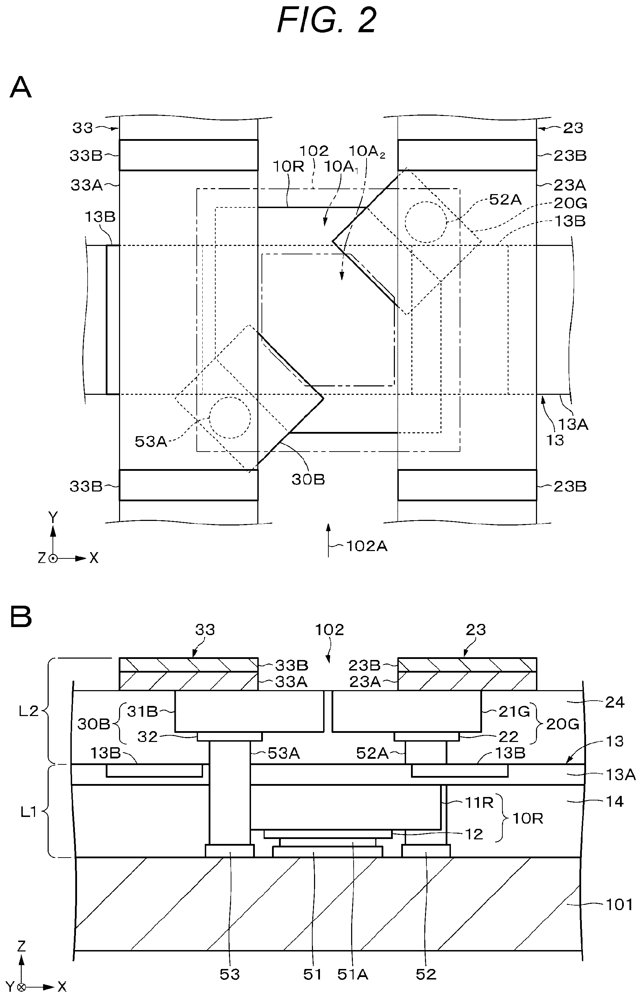

The drive substrate 101 is a so-called backplane. The drive substrate 101 drives the plurality of pixels 102. As illustrated in Fig. 2B, a plurality of pads 51, a plurality of pads 52, and a plurality of pads 53 are provided on the first surface of the drive substrate 101. Although not illustrated, a plurality of drive circuits, video display drivers, and the like are also provided on the first surface of the drive substrate 101.

The substrate body of the drive substrate 101 may include, for example, a semiconductor easily formed with a transistor or the like, or may include glass or resin having low moisture and oxygen permeability. Specifically, the substrate body may include a semiconductor substrate, a glass substrate, a resin substrate, and the like. The semiconductor substrate includes, for example, amorphous silicon, polycrystalline silicon, monocrystalline silicon, or the like. The glass substrate includes, for example, high strain point glass, soda glass, borosilicate glass, forsterite, lead glass, quartz glass, or the like. The resin substrate includes, for example, at least one selected from a group including polymethyl methacrylate, polyvinyl alcohol, polyvinyl phenol, polyethersulfone, polyimide, polycarbonate, polyethylene terephthalate, polyethylene naphthalate, and the like.

### (Pixel 102)

Fig. 2A is a plan view illustrating an example of a configuration of the pixel 102. Fig. 2B is a transparent view of the pixel 102 when viewed from the direction of an arrow 102A in Fig. 2A. The pixel 102 has a rectangular shape in plan view. In the present description, the rectangular shape includes a square shape. In the present description, the plan view means that an object is viewed from the Z-axis direction (direction perpendicular to the first surface of the drive substrate 101). Note that the shape of the pixel 102 may be a quadrangular shape (e.g. rhomboid, parallelogram) other than the square shape.

### (First layer L1, second layer L2)

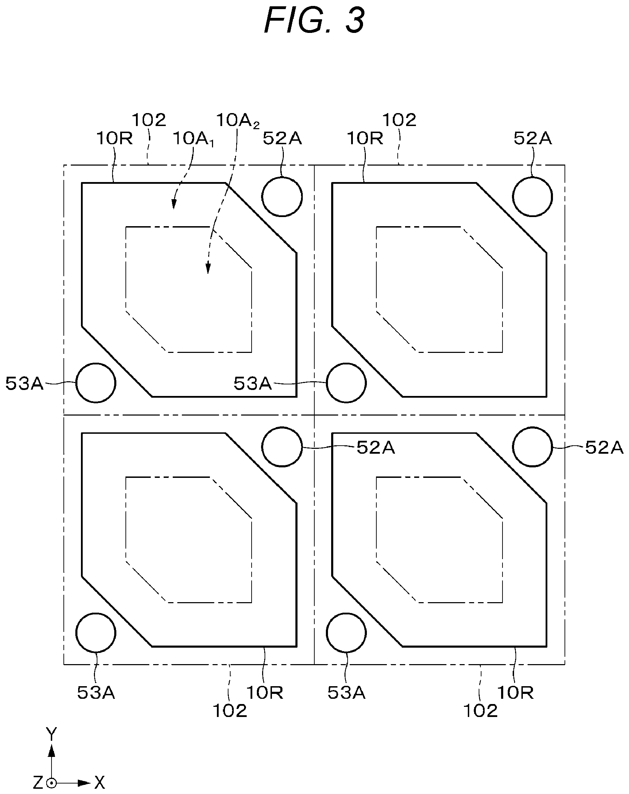

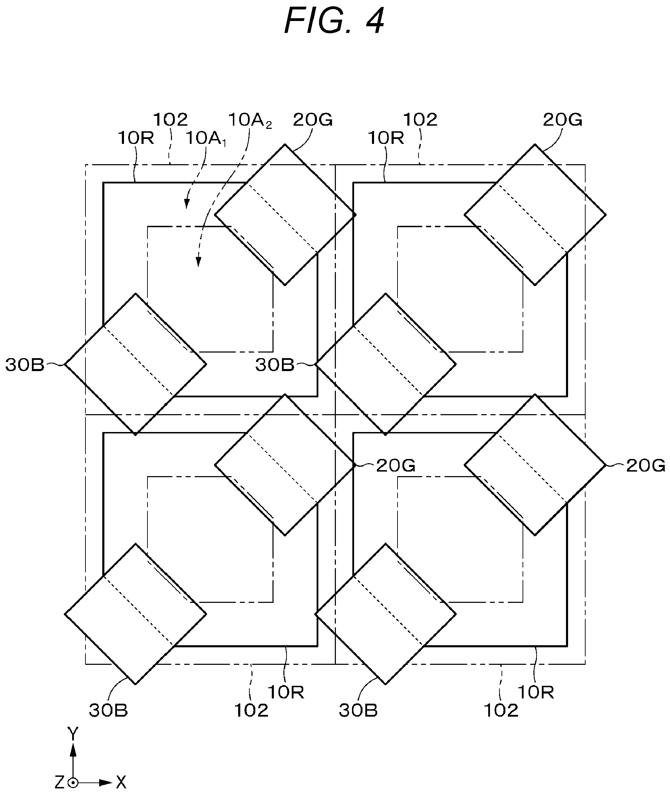

The display device 100 includes the drive substrate 101, a first layer L1, and a second layer L2 in sequence. Fig. 3 is a plan view illustrating an example of a configuration of the first layer L1. Fig. 4 is a plan view illustrating an example of a configuration of the second layer L2. As illustrated in Figs. 2A, 2B, and 3, the first layer L1 includes a plurality of first compound semiconductor light emitting elements (hereinafter, simply referred to as a "first light emitting element") 10R, a plurality of wiring lines 13, and an insulating material 14. As shown in Figs. 2A, 2B, and 4, the second layer L2 includes a plurality of second compound semiconductor light emitting elements (hereinafter, simply referred to as a "second light emitting element") 20G, a plurality of third compound semiconductor light emitting elements (hereinafter, simply referred to as a "third light emitting element") 30B, a plurality of wiring lines 23, a plurality of wiring lines 33, and an insulating material 24. The display device 100 further includes a plurality of connection members 52A and a plurality of connection members 53A provided from the first layer L1 to the second layer L2.

The first light emitting element 10R, the second light emitting element 20G, and the third light emitting element 30B are disposed to be shifted from each other in the in-plane direction. With this arrangement, red light emitted from the first light emitting element 10R can be prevented from being hindered by the second light emitting element 20G and the third light emitting element 30B. The second light emitting element 20G and the third light emitting element 30B are separated from each other in plan view. The first light emitting element 10R is provided between the second light emitting element 20G and the third light emitting element 30B in plan view. In the present description, the in-plane direction means a direction parallel to the first surface of the drive substrate 101. One pixel 102 includes one first light emitting element 10R, one second light emitting element 20G, and one third light emitting element 30B.

### (First light emitting element 10R)

The first light emitting element 10R constitutes a first subpixel. The first light emitting element 10R can emit red light. The red light is an example of first light having a first peak wavelength. The first light emitting element 10R has a hexagonal shape in plan view. The above hexagonal shape has a set of opposing substantially right-angled corners. The first light emitting element 10R is disposed in the pixel 102 such that a diagonal line connecting the set of corners described above overlaps with a first diagonal line of the pixel 102 having a rectangular shape. The plurality of first light emitting elements 10R are provided in the insulating material 14. The plurality of first light emitting elements 10R is two-dimensionally arranged in the in-plane direction in a prescribed arrangement pattern such as a matrix shape.

The first light emitting element 10R has a non-light emitting/low light emitting region (first region) 10 A₁ and a light emitting region (second region) 10A₂ on the first surface. The non-light emitting/low light emitting region 10A₁ is provided in a peripheral edge portion of the first light emitting element 10R, and is a region that cannot emit red light or can emit only red light having a lower light emission intensity than the light emitting region 10A₂. The non-light emitting/low light emitting region 10A₁ is a region having a prescribed width toward the inner side from a peripheral edge of the first surface of the first light emitting element 10R. The non-light emitting/low light emitting region 10A₁ has a closed loop shape.

The light emitting region 10A₂ is a region that is provided on the inner side of the non-light emitting/low light emitting region 10A₁ and can emit red light. The light emitting region 10A₂ has, for example, a shape similar to that of the first light emitting element 10R in plan view.

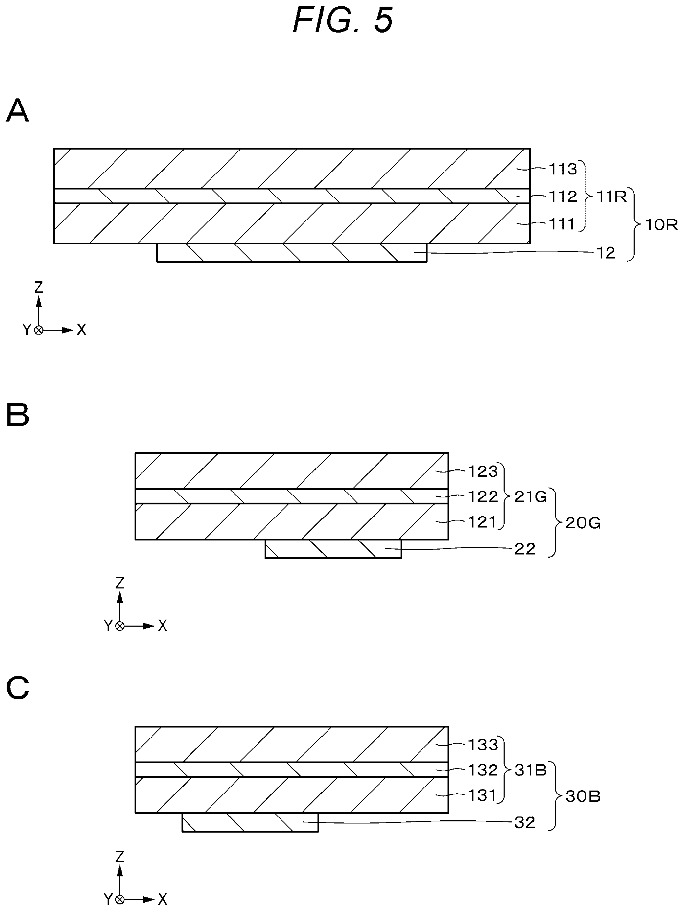

Fig. 5A is a cross-sectional view illustrating an example of a configuration of the first light emitting element 10R. The first light emitting element 10R is, for example, a red LED element. The first light emitting element 10R includes a compound semiconductor laminate 11R and an electrode 12. The compound semiconductor laminate 11R has a first surface and a second surface. The compound semiconductor laminate 11R includes a first compound semiconductor layer 111, a light emitting layer (first light emitting layer) 112, and a second compound semiconductor layer 113 in sequence on a first surface of the electrode 12.

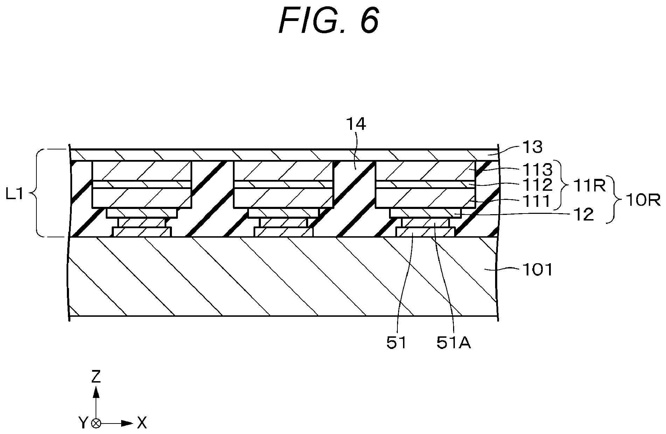

As illustrated in Fig. 6, the compound semiconductor laminate 11R and the electrode 12 are separated from those of the adjacent first light emitting elements 10R. With this arrangement, leakage of electrons and holes between the adjacent first light emitting elements 10R can be suppressed.

The light emitting layer 112 can emit red light. The first compound semiconductor layer 111, the light emitting layer 112, and the second compound semiconductor layer 113 include, for example, an AlGaInP-based compound semiconductor or an AlGaInAs-based compound semiconductor. In the light emitting layer 112 containing the AlGaInP-based compound semiconductor or the AlGaInAs-based compound semiconductor, the non-light emitting/low light emitting region 10A₁ and the light emitting region 10A₂ are generated on the first surface of the first light emitting element 10R. However, the compound semiconductor in which such a region is generated on the first surface of the first light emitting element 10R is not limited to the above material. The first compound semiconductor layer 111 has a first conductivity type, and the second compound semiconductor layer 113 has a second conductivity type opposite to the first conductivity type. The first conductivity type may be an n-type and the second conductivity type may be a p-type, or the first conductivity type may be a p-type and the second conductivity type may be an n-type. That is, the first light emitting elements 10R may be connected to each other by anode common or cathode common.

In a case where the light emitting layer 112 contains an AlGaInP-based material or an AlGaInAs-based material, a phenomenon of non emission of red light or a phenomenon of low emission of red light in the non-light emitting/low light emitting region 10A₁ is remarkably exhibited. Therefore, in a case where the light emitting layer 112 contains the AlGaInP-based material or the AlGaInAs-based material, it is particularly effective that the area S_{R} of the first light emitting element 10R is set larger than the area S_{B} of the second light emitting element 20G and the area S_{B} of the third light emitting element 30B.

The electrode 12 is provided on the second surface of the compound semiconductor laminate 11R. The electrode 12 is connected to the pad 51 of the drive substrate 101 via a bump 51A as a connection member. The compound semiconductor laminate 11R may be directly bonded to the first surface of the drive substrate 101 by wafer bonding or the like. In this case, the electrode 12, the bump 51A, and the pad 51 may not be provided.

The electrode 12 includes, for example, at least one metal selected from a group including gold (Au), silver (Ag), palladium (Pd), platinum (Pt), nickel (Ni), aluminum (Al), titanium (Ti), tungsten (W), vanadium (V), chromium (Cr), copper (Cu), zinc (Zn), tin (Sn), and indium (In). The electrode 12 may include the at least one metal described above as a constituent element of an alloy.

The electrode 12 has, for example, a single layer configuration or a multilayer configuration. Examples of the multilayer configuration include Ti/Au, Ti/Al, Ti/Pt/Au, Ti/Al/Au, Ni/Au, AuGe/Ni/Au, Ni/Au/Pt, Ni/Pt, Pd/Pt, Ag/Pd, and the like. In a case where the electrode 12 has the multilayer configuration, the layer before "/" is positioned closer to more active layer side.

### (Second light emitting element 20G)

The second light emitting element 20G constitutes a second subpixel. The second light emitting element 20G can emit green light. The green light is an example of second light having a second peak wavelength different from the first peak wavelength. The second light emitting element 20G has a quadrangular shape such as a square shape in plan view.

The plurality of second light emitting elements 20G is provided in the insulating material 24. The plurality of second light emitting elements 20G is two-dimensionally arranged in the in-plane direction in a prescribed arrangement pattern such as a matrix shape. The second light emitting element 20G is disposed to be shifted from the first light emitting element 10R in the in-plane direction. The second light emitting element 20G is disposed on a second diagonal line of the rectangular pixel 102.

The second light emitting element 20G overlaps with a part of the first light emitting element 10R in plan view. With this arrangement, because the pixel 102 can be miniaturized, the definition of the display device 100 can be increased. In addition, the influence of the second light emitting element 20G on light extraction of the first light emitting element 10R can be suppressed. From the viewpoint of suppressing the influence of the second light emitting element 20G on light extraction of the first light emitting element 10R, the second light emitting element 20G is preferably positioned on the outer side of the light emitting region 10A₂ of the first light emitting element 10R in plan view.

The second light emitting element 20G is preferably positioned on the outer side of the light emitting region 10A₂ of the first light emitting element 10R in plan view, and preferably overlaps with a part of the non-light emitting/low light emitting region 10A₁ of the first light emitting element 10R. Specifically, a first portion of the second light emitting element 20G preferably overlaps with the non-light emitting/low light emitting region 10A₁ of the first light emitting element 10R in plan view, and a second portion of the second light emitting element 20G preferably overlaps with a region on the outer side of the first light emitting element 10R in plan view. With this arrangement, the influence of the second light emitting element 20G on light extraction of the first light emitting element 10R can be suppressed while the pixel 102 is miniaturized.

The second light emitting element 20G has a light emitting region on substantially the entire first surface (including the entire first surface). In the first embodiment, an example in which the second light emitting element 20G has the light emitting region on substantially the entire first surface of the second light emitting element 20G is described, but the second light emitting element 20G may have the non-light emitting/low light emitting region which is narrower than the non-light emitting/low light emitting region 10A₁ of the first light emitting element 10R, on the first surface of the second light emitting element 20G. The second light emitting element 20G is mounted on the first layer L1 by, for example, a mass-transfer process.

Fig. 5B is a cross-sectional view illustrating an example of a configuration of the second light emitting element 20G. The second light emitting element 20G is, for example, a green LED element. The second light emitting element 20G includes a compound semiconductor laminate 21G and an electrode 22. The compound semiconductor laminate 21G has a first surface and a second surface. The compound semiconductor laminate 21G includes a first compound semiconductor layer 121, a light emitting layer (second light emitting layer) 122, and a second compound semiconductor layer 123 in sequence on a first surface of the electrode 22.

The light emitting layer 122 can emit green light. The first compound semiconductor layer 121, the light emitting layer 122, and the second compound semiconductor layer 123 include, for example, an AlGaInN-based compound semiconductor. In the light emitting layer 122 containing the AlGaInN-based compound semiconductor, substantially the entire first surface of the second light emitting element 20G becomes a light emitting region. However, the compound semiconductor in which the substantially the entire first surface of the second light emitting element 20G becomes the light emitting region is not limited to the above material. The first compound semiconductor layer 121 has a first conductivity type, and the second compound semiconductor layer 123 has a second conductivity type opposite to the first conductivity type. The first conductivity type may be an n-type and the second conductivity type may be a p-type, or the first conductivity type may be a p-type and the second conductivity type may be an n-type. That is, the second light emitting elements 20G may be connected to each other by anode common or cathode common.

The electrode 22 is provided on the second surface of the compound semiconductor laminate 21G. The electrode 22 is connected to the pad 52 of the drive substrate 101 via the connection member 52A. The connection member 52A is preferably positioned on the outer side of the first light emitting element 10R in plan view. With this arrangement, decrease in the light emitting region 10A₂ of the first light emitting element 10R can be suppressed. The connection member 52A is, for example, a via or the like. The electrode 22 has a single layer configuration or a multilayer configuration. The electrode 22 may include a material similar to that of the electrode 12.

### (Third light emitting element 30B)

The third light emitting element 30B constitutes a third subpixel. The third light emitting element 30B can emit blue light. The blue light is an example of third light having a third peak wavelength different from the first peak wavelength and the second peak wavelength. The third light emitting element 30B has a quadrangular shape such as a square shape in plan view.

The plurality of third light emitting elements 30B is provided in the insulating material 24. The plurality of third light emitting elements 30B is two-dimensionally arranged in the in-plane direction in a prescribed arrangement pattern such as a matrix shape. The third light emitting element 30B is disposed to be shifted from the first light emitting element 10R in the in-plane direction.

The third light emitting element 30B is disposed on the second diagonal line of the rectangular pixel 102. The direction of the shift of the third light emitting element 30B with respect to the first light emitting element 10R is opposite to the direction of the shift of the second light emitting element 20G with respect to the first light emitting element 10R.

The third light emitting element 30B overlaps with a part of the first light emitting element 10R in plan view. With this arrangement, because the pixel 102 can be miniaturized, the definition of the display device 100 can be increased. In addition, the influence of the third light emitting element 30B on light extraction of the first light emitting element 10R can be suppressed. From the viewpoint of suppressing the influence of the third light emitting element 30B on light extraction of the first light emitting element 10R, the third light emitting element 30B is preferably positioned on the outer side of the light emitting region 10A₂ of the first light emitting element 10R in plan view.

The third light emitting element 30B is preferably positioned on the outer side of the light emitting region 10A₂ of the first light emitting element 10R in plan view, and preferably overlaps with a part of the non-light emitting/low light emitting region 10A₁ of the first light emitting element 10R. Specifically, a first portion of the third light emitting element 30B preferably overlaps with the non-light emitting/low light emitting region 10A₁ of the first light emitting element 10R in plan view, and a second portion of the third light emitting element 30B preferably overlaps with a region on the outer side of the first light emitting element 10R in plan view. With this arrangement, the influence of the third light emitting element 30B on light extraction of the first light emitting element 10R can be suppressed while the pixel 102 is miniaturized.

The third light emitting element 30B has a light emitting region on substantially the entire first surface (including the entire first surface). In the first embodiment, an example in which the third light emitting element 30B has the light emitting region on substantially the entire first surface of the third light emitting element 30B is described, but the third light emitting element 30B may have the non-light emitting/low light emitting region which is narrower than the non-light emitting/low light emitting region 10A₁ of the first light emitting element 10R, on the first surface of the third light emitting element 30B. The third light emitting element 30B is mounted on the first layer L1 by, for example, a mass-transfer process.

Fig. 5C is a cross-sectional view illustrating an example of a configuration of the third light emitting element 30B. The third light emitting element 30B is, for example, a blue LED element. The third light emitting element 30B includes a compound semiconductor laminate 31B and an electrode 32. The compound semiconductor laminate 31B has a first surface and a second surface. The compound semiconductor laminate 31B includes a first compound semiconductor layer 131, a light emitting layer (third light emitting layer) 132, and a second compound semiconductor layer 133 in sequence on a second surface of the electrode 32.

The light emitting layer 132 can emit blue light. The first compound semiconductor layer 131, the light emitting layer 132, and the second compound semiconductor layer 133 include, for example, an AlGaInN-based compound semiconductor. In the light emitting layer 132 containing the AlGaInN-based compound semiconductor, substantially the entire first surface of the third light emitting element 30B becomes a light emitting region. However, the compound semiconductor in which the substantially the entire first surface of the third light emitting element 30B becomes the light emitting region is not limited to the above material. The first compound semiconductor layer 131 has a first conductivity type, and the second compound semiconductor layer 133 has a second conductivity type opposite to the first conductivity type. The first conductivity type may be an n-type and the second conductivity type may be a p-type, or the first conductivity type may be a p-type and the second conductivity type may be an n-type. That is, the third light emitting elements 30B may be connected to each other by anode common or cathode common.

The electrode 32 is provided on the second surface of the compound semiconductor laminate 31B. The electrode 32 is connected to the pad 53 of the drive substrate 101 via a connection member 53A. The connection member 53A is preferably positioned on the outer side of the first light emitting element 10R in plan view. With this arrangement, decrease in the light emitting region 10A₂ of the first light emitting element 10R can be suppressed. The connection member 53A is, for example, a via or the like. The electrode 32 has a single layer configuration or a multilayer configuration. The electrode 32 may include a material similar to that of the electrode 12.

### (Sizes of first light emitting element 10R, second light emitting element 20G, and third light emitting element 30B)

In the first light emitting element (for example, red LED element) 10R that can emit red light, the non-light emitting/low light emitting region 10A₁ as described above is generated. On the other hand, in the second light emitting element (for example, green LED element) 20G that can emit green light and the third light emitting element (for example, blue LED element) 30B that can emit blue light, the non-light emitting/low light emitting region seen in the first light emitting element 10R is not generated, or even if the non-light emitting/low light emitting region is generated, the area of the non-light emitting/low light emitting region is extremely small as compared with the non-light emitting/low light emitting region 10A₁ of the first light emitting element 10R.

Therefore, by miniaturizing the first light emitting element 10R, the ratio of the area of the non-light emitting/low light emitting region 10A₁ to the area of the light emitting region 10A₂ increases, and there is a possibility that the light emission efficiency of the first light emitting element 10R decreases. On the other hand, even if the second light emitting element 20G and the third light emitting element 30B are miniaturized, the possibility that the light emission efficiency decreases as in the case of the first light emitting element 10R is low.

In the example, in order to suppress decrease in light emission efficiency of the first light emitting element 10R, the area S_{R} of the first light emitting element 10R is larger than the area S_{B} of the second light emitting element 20G, and the area S_{R} of the first light emitting element 10R is larger than the area S_{B} of the third light emitting element 30B. In the present description, the area S_{R} of the first light emitting element 10R, the area S_{B} of the second light emitting element 20G, and the area S_{B} of the third light emitting element 30B all mean the area in plan view (that is, the area of the first surface).

The area of the first light emitting element 10R is preferably larger than one-third of the area of one pixel 102. With this arrangement, even if the first light emitting element 10R has the non-light emitting/low light emitting region 10A₁, decrease in luminance of the first light emitting element 10R can be suppressed.

The total sum S_{RGB} (= S_{R} + S_{G} + S_{B}) of the area S_{R} of the first light emitting element 10R, the area S_{G} of the second light emitting element 20G, and the area S_{B} of the third light emitting element 30B, is preferably larger than one time the area S_{P} of one pixel 102 and smaller than three times the area S_{PIX} of one pixel 102. That is, it is preferable that the total sum S_{RGB} of the areas S_{R}, S_{G}, and S_{B} and the area S_{PIX} of one pixel 102 satisfy the relationships of S_{RGB} > S_{PIX} and S_{RGB} < S_{PIX} × 3.

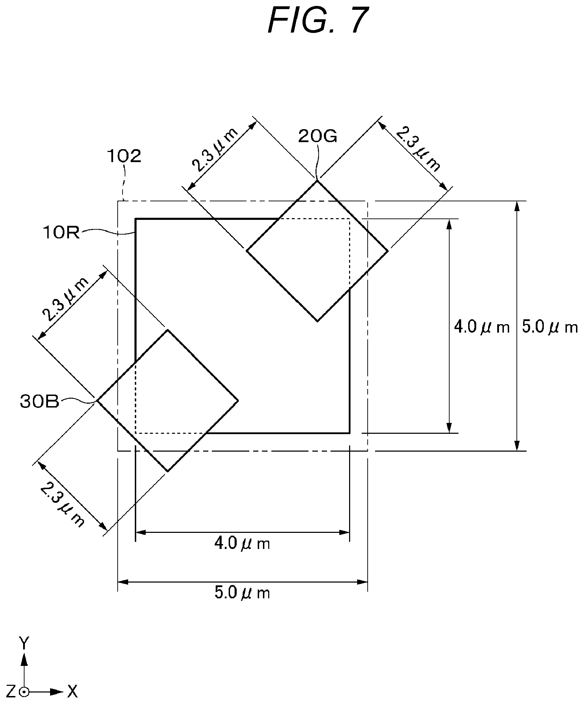

An example of the total sum S_{RGB} of the area S_{R} of the first light emitting element 10R, the area S_{G} of the second light emitting element 20G, and the area S_{B} of the third light emitting element 30B, and an area S_{PIX} of one pixel 102 is described with reference to Fig. 7. In the example illustrated in Fig. 7, the area S_{R} of the first light emitting element 10R, the area S_{G} of the second light emitting element 20G, and the area S_{B} of the third light emitting element 30B, the total sum S_{RGB} of the area S_{R}, the area S_{G}, and the area S_{B}, and the area S_{PIX} of one pixel 102 are as follows.
The area S_{R} of the first light emitting element 10R: 4.0 µm × 4.0 µm = 16.0 µm²
The area S_{G} of the second light emitting element 20G: 2.3 µm × 2.3 µm = 5.3 µm²
The area S_{B} of the third light emitting element 30B: 2.3 µm × 2.3 µm = 5.3 µm²
The total sum S_{RGB} of area S_{R}, area S_{G}, and area S_{B} (= S_{R} + S_{G} + S_{B}): 26.6 µm²
The area S_{PIX} of one pixel 102: 5.0 µm × 5.0 µm = 25.0 µm²

As described above, because S_{RGB} = 26.6 µm² and S_{PIX} = 25.0 µm², the relationship of S_{RGB} > S_{PIX} is satisfied. Furthermore, because three times the area S_{PIX} of one pixel 102 (S_{PIX} × 3) is 25.0 µm² × 3 = 75.0 µm², the relationship of S_{RGB} < S_{PIX} × 3 is satisfied.

In a case where the total sum S_{RGB} (= S_{R} + S_{G} + S_{B}) of the area S_{R} of the first light emitting element 10R, the area S_{G} of the second light emitting element 20G, and the area S_{B} of the third light emitting element 30B is larger than one time the area S_{PIX} of one pixel 102, the size of the pixel 102 can be miniaturized as compared with the pixel in which the first light emitting element 10R, the second light emitting element 20G, and the third light emitting element 30B are densely arranged in the same plane.

In a case where the total sum S_{RGB} (= S_{R} + S_{G} + S_{B}) of the area S_{R} of the first light emitting element 10R, the area S_{G} of the second light emitting element 20G, and the area S_{B} of the third light emitting element 30B is smaller than three times the area S_{PIX} of one pixel 102, the first light emitting element 10R, the second light emitting element 20G, and the third light emitting element 30B can be suppressed from being overlapped with each other excessively. For example, in a case where the first light emitting element 10R, the second light emitting element 20G, and the third light emitting element 30B have the same shape and the same size, the first light emitting element 10R, the second light emitting element 20G, and the third light emitting element 30B can be suppressed from being completely overlapped with each other.

### (Carrier diffusion wavelength)

The carrier diffusion length of the light emitting layer 112 of the first light emitting element 10R is longer than the carrier diffusion length of the light emitting layer 122 of the second light emitting element 20G. In a case where the light emitting layer 112 and the light emitting layer 122 have such a carrier diffusion length relationship, the light emitting layer 112 and the light emitting layer 122 have light emission characteristics shown in the following (1) or (2).
(1) The first light emitting element 10R has the non-light emitting/low light emitting region 10A₁ on the first surface of the first light emitting element 10R, whereas the second light emitting element 20G has substantially no non-light emitting/low light emitting region 10A₁ on the first surface of the second light emitting element 20G.
(2) Both the first light emitting element 10R and the second light emitting element 20G have the non-light emitting/low light emitting region 10A₁ on the first surface, but the width of the non-light emitting/low light emitting region 10A₁ of the second light emitting element 20G is narrower than the width of the non-light emitting/low light emitting region 10A₁ of the first light emitting element 10R.
   The carrier diffusion length of the light emitting layer 112 of the first light emitting element 10R is longer than the carrier diffusion length of the light emitting layer 132 of the third light emitting element 30B. In a case where the light emitting layer 112 and the light emitting layer 132 have such a carrier diffusion length relationship, the light emitting layer 112 and the light emitting layer 122 have light emission characteristics shown in the following (3) or (4).
(3) The first light emitting element 10R has the non-light emitting/low light emitting region 10A₁ on the first surface of the first light emitting element 10R, whereas the third light emitting element 30B has substantially no non-light emitting/low light emitting region 10A₁ on the first surface of the third light emitting element 30B.
(4) Both the first light emitting element 10R and the third light emitting element 30B have the non-light emitting/low light emitting region 10A₁ on the first surface, but the width of the non-light emitting/low light emitting region 10A₁ of the third light emitting element 30B is narrower than the width of the non-light emitting/low light emitting region 10A₁ of the first light emitting element 10R.

### (Wiring line 13, wiring line 23, and wiring line 33)

Each of the wiring lines 13 electrically connects the plurality of first light emitting elements 10R aligned in one row in the X-axis direction. The wiring lines 13 are provided on the insulating material 14. The plurality of wiring lines 13 each extends in the X-axis direction. The wiring lines 13 adjacent to each other in the Y-axis direction are spaced apart from each other by a prescribed interval. Each of the wiring lines 13 is connected to the first surface of the compound semiconductor laminate 11R of each of the plurality of first light emitting elements 10R aligned in one row in the X-axis direction. The wiring line 13 includes a transparent wiring line 13A and a plurality of metal wiring lines 13B. Each of the plurality of metal wiring lines 13B is provided on the first surface of the transparent wiring line 13A at a prescribed interval. The metal wiring line 13B is an auxiliary member for reducing the resistance of the wiring line 13.

The transparent wiring line 13A has transparency to visible light. The transparent wiring line 13A includes, for example, a transparent conductive material. The transparent conductive material preferably includes a transparent conductive oxide. The transparent conductive oxide includes, for example, indium oxide, indium-tin oxide (ITO, including Sn-doped In₂O₃, crystalline ITO, and amorphous ITO), indium-zinc oxide (IZO), indium-gallium oxide (IGO), indium-doped gallium-zinc oxide (IGZO, In-GaZnO₄), F-doped In₂O₃ (IFO), tin oxide (SnO₂), Sb-doped SnO₂ (ATO), F-doped SnO₂ (FTO), zinc oxide (ZnO, including Al-doped ZnO, B-doped ZnO, and Ga-doped ZnO), antimony oxide, spinel type oxide, and oxide having a YbFe₂O₄ structure. The transparent wiring line 13A may be a transparent conductive layer including gallium oxide, titanium oxide, niobium oxide, nickel oxide, or the like as a base layer.

The metal wiring line 13B includes, for example, at least one metal element selected from a group including chromium (Cr), gold (Au), platinum (Pt), nickel (Ni), copper (Cu), molybdenum (Mo), titanium (Ti), tantalum (Ta), aluminum (Al), magnesium (Mg), iron (Fe), tungsten (W), and silver (Ag). The metal wiring line 13B may include the at least one metal element described above as a constituent element of an alloy.

Each of the wiring lines 23 electrically connects the plurality of second light emitting elements 20G aligned in one row in the Y-axis direction. Each of the wiring lines 33 electrically connects the plurality of third light emitting elements 30B aligned in one row in the Y-axis direction. The wiring lines 23 and the wiring lines 33 are provided on the insulating material 24. The plurality of wiring lines 23 each extends in the Y-axis direction. Similarly, the plurality of wiring lines 33 each extends in the Y-axis direction. The wiring lines 23 and the wiring lines 33 are alternately provided in the X-axis direction. The wiring line 23 and the wiring line 33 adjacent to each other in the X-axis direction are spaced apart from each other by a prescribed interval. The wiring line 23 is connected to the first surface of the compound semiconductor laminate 21G of each of the plurality of second light emitting elements 20G aligned in one row in the Y-axis direction. The wiring line 33 is connected to the first surface of the compound semiconductor laminate 31B of each of the plurality of third light emitting elements 30B aligned in one row in the Y-axis direction.

The wiring line 23 includes a transparent wiring line 23A and a plurality of metal wiring lines 23B. Each of the plurality of metal wiring lines 23B is provided on the first surface of the transparent wiring line 23A in the longitudinal direction of the wiring line 23 at a prescribed interval. The metal wiring line 23B is an auxiliary member for reducing the resistance of the wiring line 23. The wiring line 33 includes a transparent wiring line 33A and a plurality of metal wiring lines 33B. Each of the plurality of metal wiring lines 33B is provided on the first surface of the transparent wiring line 33A in the longitudinal direction of the wiring line 23 at a prescribed interval. The metal wiring line 33B is an auxiliary member for reducing the resistance of the wiring line 33. The transparent wiring line 23A and the transparent wiring line 33A may contain a material similar to that of the transparent wiring line 13A. The metal wiring line 23B and the metal wiring line 33B may include a material similar to that of the metal wiring line 13B.

The wiring line 23 is preferably positioned on the outer side of each of the light emitting regions 10A₂ of the plurality of first light emitting elements 10R aligned in one row in the Y-axis direction in plan view. With this arrangement, the influence of the wiring line 23 on light extraction of the first light emitting element 10R can be suppressed. The wiring line 33 is preferably positioned on the outer side of each of the light emitting regions 10A₂ of the plurality of first light emitting elements 10R aligned in one row in the Y-axis direction in plan view. With this arrangement, the influence of the wiring line 33 on light extraction of the first light emitting element 10R can be suppressed.

In plan view, the wiring line 23 is preferably positioned on the outer side of each light emitting region 10A₂ of the first light emitting element 10R aligned in one row in the Y-axis direction, and preferably overlaps with a part of the non-light emitting/low light emitting region 10A₁ of the plurality of first light emitting elements 10R aligned in one row in the Y-axis direction. In this case, the influence of the wiring line 23 on light extraction of the first light emitting element 10R can be suppressed, and meanwhile, the interval between the wiring line 23 and the wiring line 33 adjacent to each other in the X-axis direction can be further narrowed.

In plan view, the wiring line 33 is preferably positioned on the outer side of each light emitting region 10A₂ of the first light emitting element 10R aligned in one row in the Y-axis direction, and preferably overlaps with a part of the non-light emitting/low light emitting region 10A₁ of the plurality of first light emitting elements 10R aligned in one row in the Y-axis direction. In this case, the influence of the wiring line 33 on light extraction of the first light emitting element 10R can be suppressed, and meanwhile, the interval between the wiring line 23 and the wiring line 33 adjacent to each other in the X-axis direction can be further narrowed.

### (Insulating material 14 and 24)

The insulating material 14 and the insulating material 24 may be an organic material, an inorganic material, or a laminate thereof. The organic insulating material includes, for example, at least one selected from a group including a polyimide-based resin, an acrylic resin, a novolac-based resin, and the like. The inorganic insulating material includes, for example, at least one selected from a group including silicon oxide (SiOₓ), silicon nitride (SiNₓ), silicon oxynitride (SiOₓN_{y}), and the like.

### [Action and effect]

A conventional display device includes light emitting elements (compound semiconductor light emitting elements) of three colors (red, green, and blue) in a single layer on a first surface of a drive substrate. Therefore, by miniaturizing the size of the pixel, the size of the light emitting element of each color decreases accordingly. Because a red light emitting element (for example, a red LED element) among the light emitting elements of the three colors has a non-light emitting/low light emitting region in the peripheral edge portion, by reducing the size of the red light emitting element, the ratio of the area of the non-light emitting/low light emitting region to the light emitting region of the light emitting element increases. Therefore, the light emission efficiency of the red compound semiconductor light emitting element decreases.

On the other hand, the display device 100 according to the first embodiment includes the first layer L1 and the second layer L2 in sequence on the first surface of the drive substrate 101. The second layer L2 includes the compound semiconductor light emitting elements of two colors, which are the second light emitting element 20G and the third light emitting element 30B, whereas the first layer L1 includes the compound semiconductor light emitting elements of one color, which is the first light emitting element 10R. With this arrangement, the size of the first light emitting element 10R can be set independently of the second light emitting element 20G and the third light emitting element 30B. Therefore, even in a case where the size of the pixel 102 is miniaturized, decrease in the size of the first light emitting element 10R can be suppressed accordingly. Therefore, the ratio of the area of the non-light emitting/low light emitting region 10A₁ to the area of the light emitting region 10A₂ of the first light emitting element 10R increases, and decrease in the light emission efficiency of the first light emitting element 10R can be suppressed.

In the display device 100 according to the first embodiment, the first light emitting element 10R, the second light emitting element 20G, and the third light emitting element 30B are disposed to be shifted from each other in the in-plane direction. With this arrangement, decrease in luminance can be suppressed as compared with the conventional display device (see Patent Document 1) in which light emitting elements (compound semiconductor light emitting elements) of three colors (red, green, and blue) are laminated.

In the display device 100 according to the first embodiment, the first light emitting element 10R included in the first layer L1 is disposed to be shifted from the second light emitting element 20G and the third light emitting element 30B included in the second layer L2. With this arrangement, red light emitted from the first light emitting element 10R can be prevented from being hindered by the second light emitting element 20G and the third light emitting element 30B. Therefore, decrease in red light luminance can be suppressed.

In the display device 100 according to the first embodiment, the first layer L1 includes a light emitting element of one color (the first light emitting element 10R) and the second layer L2 includes light emitting elements of two colors (the second light emitting element 20G and the third light emitting element 30B). On the other hand, in the above-described conventional display device, a single layer includes light emitting elements of three colors. Therefore, in the display device 100 according to the first embodiment, the interval between the second light emitting element 20G and the third light emitting element 30B can be made wider than the interval between the light emitting elements of the three colors in the conventional display device described above. Therefore, in the display device 100 according to the first embodiment, the mounting accuracy of the second light emitting element 20G and the third light emitting element 30B can be relaxed more than the mounting accuracy of the light emitting elements of the three colors in the conventional display device.

Furthermore, in the display device 100 according to the first embodiment, the mounting accuracy of the first light emitting element 10R can be relaxed more than the mounting accuracy of the light emitting elements of the three colors in the conventional display device.

In the display device 100 according to the first embodiment, the second light emitting element 20G is positioned on the outer side of the light emitting region 10A₂ of the first light emitting element 10R in plan view, and overlaps with a part of the non-light emitting/low light emitting region 10A₁ of the first light emitting element 10R. Furthermore, the third light emitting element 30B is positioned on the outer side of the light emitting region 10A₂ of the first light emitting element 10R in plan view, and overlaps with a part of the non-light emitting/low light emitting region 10A₁ of the first light emitting element 10R. With this arrangement, the influence of the second light emitting element 20G and the third light emitting element 30B on light extraction of the first light emitting element 10R can be suppressed while the pixel 102 is miniaturized.

The wiring line 23 is provided in the region on the outer side of the light emitting region 10A₂ of the first light emitting element 10R in plan view. Furthermore, the wiring line 33 is provided in the region on the outer side of the light emitting region 10A₂ of the first light emitting element 10R in plan view. With this arrangement, the influence of the wiring line 23 and the wiring line 33 on light extraction of the first light emitting element 10R can be suppressed.

### <2 Embodiment>

### [Configuration of display device]

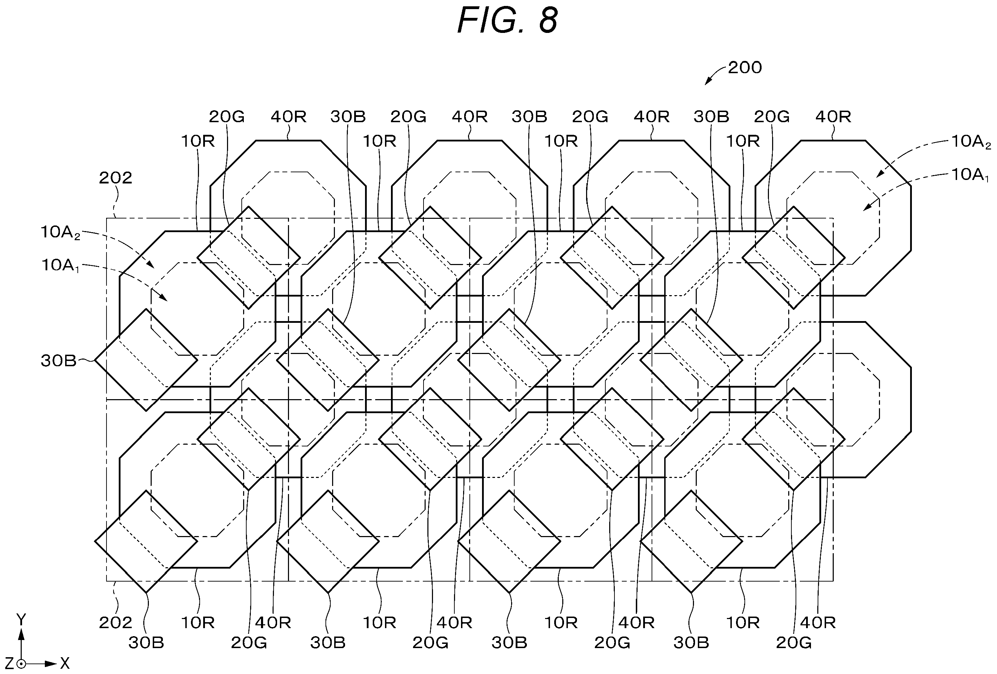

Fig. 8 is a plan view illustrating a configuration of a display device 200 according to an embodiment of the present invention.

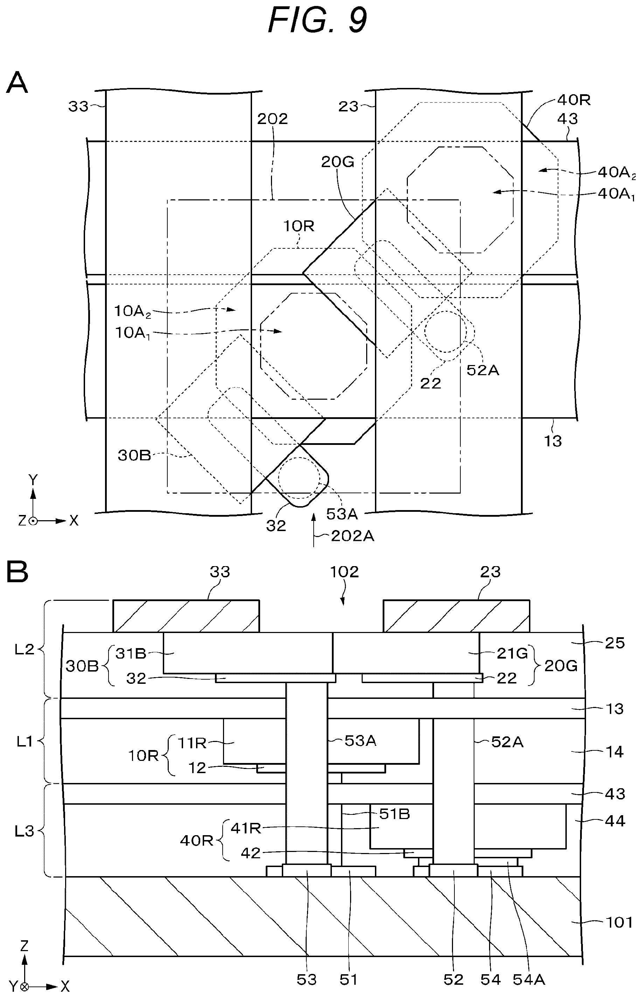

Fig. 9A is a plan view illustrating an example of a configuration of a pixel 202. Fig. 9B is a transparent view of the pixel 202 when viewed from the direction of an arrow 202A in Fig. 9A. The display device 200 is different from the display device 100 according to the example in that the display device 200 further includes a third layer L3 and includes a drive substrate 201 instead of the drive substrate 101.

### (Drive substrate 201)

The drive substrate 201 drives a plurality of the pixels 202. A plurality of pads 51, a plurality of pads 52, a plurality of pads 53, and a plurality of pads 54 are provided on a first surface of the drive substrate 201.

### (Third layer L3)

A third layer L3 is provided between the drive substrate 201 and a first layer L1. The third layer L3 includes a plurality of fourth compound semiconductor light emitting elements (hereinafter, simply referred to as a "fourth light emitting element") 40R, a plurality of wiring lines 43, and an insulating material 44. One pixel 402 includes one first light emitting element 10R, one second light emitting element 20G, one third light emitting element 30B, and one-quarter of the fourth light emitting element 40R.

### (Fourth light emitting element 40R)

The fourth light emitting element 40R constitutes a fourth subpixel. The fourth light emitting element 40R can emit light of the same color as the first light emitting element 10R, that is, red light. The red light is an example of fourth light having a fourth peak wavelength. The fourth light emitting element 40R has a hexagonal shape in plan view. The fourth light emitting element 40R is disposed such that the center of the fourth light emitting element 40R is positioned at a corner of the pixel 402 having a rectangular shape in plan view. The plurality of fourth light emitting elements 40R is provided in the insulating material 44. The plurality of fourth light emitting element 40R is two-dimensionally arranged in the in-plane direction in a prescribed arrangement pattern such as a matrix shape. The first light emitting element 10R and the fourth light emitting element 40R are separated from each other in plan view. The fourth light emitting element 40R is provided between the second light emitting element 20G and the third light emitting element 30B in plan view.

The fourth light emitting element 40R has a non-light emitting/low light emitting region (third region) 40A₁ and a light emitting region (fourth region) 40A₂ on a first surface. The non-light emitting/low light emitting region 40A₁ and the light emitting region 40A₂ are similar to the non-light emitting/low light emitting region 10A₁ and the light emitting region 10A₂ of the first light emitting element 10R.

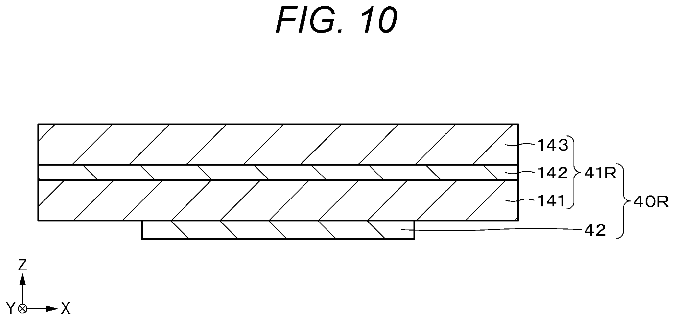

Fig. 10 is a cross-sectional view illustrating an example of a configuration of the fourth light emitting element 40R. The fourth light emitting element 40R is, for example, a red LED element. The fourth light emitting element 40R includes a compound semiconductor laminate 41R and an electrode 42. The compound semiconductor laminate 41R has a first surface and a second surface. The compound semiconductor laminate 41R includes a first compound semiconductor layer 141, a light emitting layer (fourth light emitting layer) 142, and a second compound semiconductor layer 143 in sequence on a first surface of the electrode 42. The first compound semiconductor layer 141, the light emitting layer 142, and the second compound semiconductor layer 143 may be similar to the first compound semiconductor layer 111, the light emitting layer 112, and the second compound semiconductor layer 113 of the first light emitting element 10R, respectively.

The compound semiconductor laminate 41R and the electrode 42 are separated from those of the adjacent fourth light emitting elements 40R. With this arrangement, leakage of electrons and holes between the adjacent fourth light emitting elements 40R can be suppressed.

The electrode 42 is provided on the second surface of the compound semiconductor laminate 41R. The electrode 42 is connected to a pad 54 of the drive substrate 201 via a bump 54A as a connection member. The compound semiconductor laminate 41R may be directly bonded to the first surface of the drive substrate 201 by wafer bonding or the like. In this case, the electrode 42, the bump 54A, and the pad 54 may not be provided. The electrode 42 has a single layer configuration or a multilayer configuration. The electrode 42 may include a material similar to that of the electrode 12.

### (First light emitting element 10R)

In the embodiment, the third layer L3 is provided between the drive substrate 201 and the first layer L1. Therefore, the electrode 12 of the first light emitting element 10R is connected to the pad 51 of the drive substrate 201 via a connection member 51B such as a via instead of the bump 51A.

### (Second light emitting element 20G)

The second light emitting element 20G overlaps with a part of the fourth light emitting element 40R in plan view. With this arrangement, because the pixel 202 can be miniaturized, the definition of the display device 200 can be increased. In addition, the influence of the second light emitting element 20G on light extraction of the fourth light emitting element 40R can be suppressed. From the viewpoint of suppressing the influence of the second light emitting element 20G on light extraction of the fourth light emitting element 40R, the second light emitting element 20G is preferably positioned on the outer side of the light emitting region 40A₂ of the fourth light emitting element 40R in plan view.

The second light emitting element 20G is preferably positioned on the outer side of the light emitting region 40A₂ of the fourth light emitting element 40R in plan view, and preferably overlaps with a part of the non-light emitting/low light emitting region 40A₁ of the fourth light emitting element 40R. Specifically, a first portion of the second light emitting element 20G preferably overlaps with the non-light emitting/low light emitting region 40A₁ of the fourth light emitting element 40R in plan view, and a second portion of the second light emitting element 20G preferably overlaps with a region on the outer side of the fourth light emitting element 40R in plan view. With this arrangement, the influence of the second light emitting element 20G on light extraction of the fourth light emitting element 40R can be suppressed while the pixel 202 is miniaturized.

### (Third light emitting element 30B)

The third light emitting element 30B overlaps with a part of the fourth light emitting element 40R in plan view. With this arrangement, because the pixel 202 can be miniaturized, the definition of the display device 200 can be increased. In addition, the influence of the third light emitting element 30B on light extraction of the fourth light emitting element 40R can be suppressed. From the viewpoint of suppressing the influence of the third light emitting element 30B on light extraction of the fourth light emitting element 40R, the third light emitting element 30B is preferably positioned on the outer side of the light emitting region 40A₂ of the fourth light emitting element 40R in plan view.

The third light emitting element 30B is preferably positioned on the outer side of the light emitting region 40A₂ of the fourth light emitting element 40R in plan view, and preferably overlaps with a part of the non-light emitting/low light emitting region 40A₁ of the fourth light emitting element 40R. Specifically, a first portion of the third light emitting element 30B preferably overlaps with the non-light emitting/low light emitting region 40A₁ of the fourth light emitting element 40R in plan view, and a second portion of the third light emitting element 30B preferably overlaps with a region on the outer side of the fourth light emitting element 40R in plan view. With this arrangement, the influence of the third light emitting element 30B on light extraction of the fourth light emitting element 40R can be suppressed while the pixel 202 is miniaturized.

### (Wiring line 43)

Each of the wiring lines 43 electrically connects the plurality of fourth light emitting elements 40R aligned in one row in the X-axis direction. The wiring lines 43 are provided on the insulating material 44. The plurality of wiring lines 43 each extends in the X-axis direction. The wiring lines 43 adjacent to each other in the Y-axis direction are spaced apart from each other by a prescribed interval. Each of the wiring lines 43 is connected to the first surface of the compound semiconductor laminate 41R of each of the plurality of fourth light emitting elements 40R aligned in one row in the X-axis direction. The wiring line 43 may have the similar configuration to the wiring line 13.

### (Insulating material 44)

The insulating material 44 may include materials similar to the insulating material 14 and the insulating material 24.

### [Action and effect]

The display device 200 according to the second embodiment further includes, between the drive substrate 11 and the first layer L1, the plurality of fourth light emitting elements 40R that can emit red light.
Therefore, the number of red light emitting elements per pixel 202 can be increased as compared with the display device 100 according to the first embodiment. Therefore, by miniaturizing the first light emitting element 10R, even in a case where the ratio of the area of the non-light emitting/low light emitting region 10A₁ to the area of the light emitting region 10A₂ of the first light emitting element 10R increases, decrease in the red light luminance can be suppressed.

### <3 Modification>

### (Modification 1)

In the example, an example has been described in which the first light, the second light, and the third light are red light, green light, and blue light, respectively. However, the first light, the second light, and the third light are not limited to light of these colors. At least one type of light selected from the group including the first light, the second light, and the third light may be light of a color other than red light, green light, or blue light. At least one type of light selected from the group including the first light, the second light, and the third light may be light other than visible light. For example, the first light may be infrared light. At least one type of light selected from the group including the second light and the third light may be ultraviolet light.

The compound semiconductor laminate 11R of the first light emitting element 10R that can emit infrared light can include the similar based material as the compound semiconductor laminate 11R of the first light emitting element 10R that can emit red light. Therefore, the first light emitting element 10R that can emit infrared light has a non-light emitting/low light emitting region (first region) 10R₁ and a light emitting region (second region) 10R₂. Therefore, even in a case where the display device 100 includes the first light emitting element 10R that can emit infrared light, the similar operational effects as those of the first embodiment can be obtained.

The compound semiconductor laminate 21G of the second light emitting element 20G that can emit ultraviolet light can include the similar based material as the compound semiconductor laminate 21G of the second light emitting element 20G that can emit green light. The compound semiconductor laminate 31B of the third light emitting element 30B that can emit ultraviolet light can include the similar based material as the compound semiconductor laminate 31B of the third light emitting element 30B that can emit blue light. Therefore, in the second light emitting element 20G that can emit ultraviolet light and the third light emitting element 30B that can emit ultraviolet light, the non-light emitting/low light emitting region is not generated, or even if the region is generated, the area of the region is extremely small. Therefore, even in a case where the display device 100 includes at least one selected from the group including the second light emitting element 20G that can emit ultraviolet light and the third light emitting element 30B that can emit ultraviolet light, the similar operational effects as those of the first embodiment can be obtained.

In the embodiment, an example has been described in which the first light, the second light, the third light, and the fourth light are red light, green light, blue light, and red light, respectively. However, the first light, the second light, the third light, and the fourth light are not limited to light of these colors. At least one type of light selected from the group including the first light, the second light, the third light, and the fourth light may be light of a color other than red light, green light, or blue light. At least one type of light selected from the group including the first light, the second light, the third light, and the fourth light may be light other than visible light. For example, at least one type of light selected from the group including the first light emitting element 10R and the fourth light emitting element 40R may be infrared light. At least one type of light selected from the group including the second light emitting element 20G and the third light emitting element 30B may be ultraviolet light.

### (Modification 2)

In the example and embodiment, an example has been described in which the second layer L2 includes two types of light emitting elements, that is, the second light emitting element 20G that can emit green light and the third light emitting element 30B that can emit blue light, but the configuration of the second layer L2 is not limited thereto. For example, the second layer L2 may include any one of the second light emitting element 20G that can emit green light and the third light emitting element 30B that can emit blue light.

In a case where the second layer L2 includes only one type of light emitting element, which is the second light emitting element 20G, the second light emitting element 20G may be provided instead of the third light emitting element 30B at the arrangement position of the third light emitting element 30B in the first and second embodiments. In a case where the second layer L2 includes only one type of light emitting element, which is the third light emitting element 30B, the third light emitting element 30B may be provided instead of the second light emitting element 20G at the arrangement position of the second light emitting element 20G in the first and second embodiments.

### (Modification 3)

In the embodiment, an example has been described in which the compound semiconductor laminate 11R and the electrode 12 are separated from those of the adjacent first light emitting elements 10R as shown in Fig. 6, but the configuration of the first layer L1 is not limited thereto.

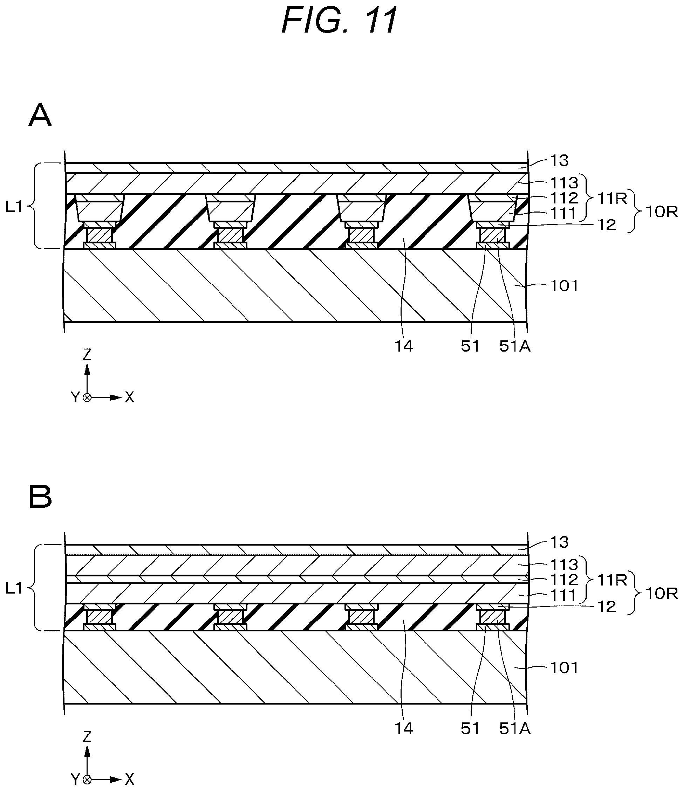

For example, as illustrated in Fig. 11A, the second compound semiconductor layer 113 may be connected over the adjacent first light emitting elements 10R and shared among the plurality of first light emitting elements 10R, whereas the light emitting layer 112, the first compound semiconductor layer 111, and the electrode 12 may be separated from those of the adjacent first light emitting elements 10R.

For example, as illustrated in Fig. 11B, the compound semiconductor laminate 11R may be connected over the adjacent first light emitting elements 10R and shared among the plurality of first light emitting elements 10R, whereas the electrode 12 may be separated from those of the adjacent first light emitting elements 10R.

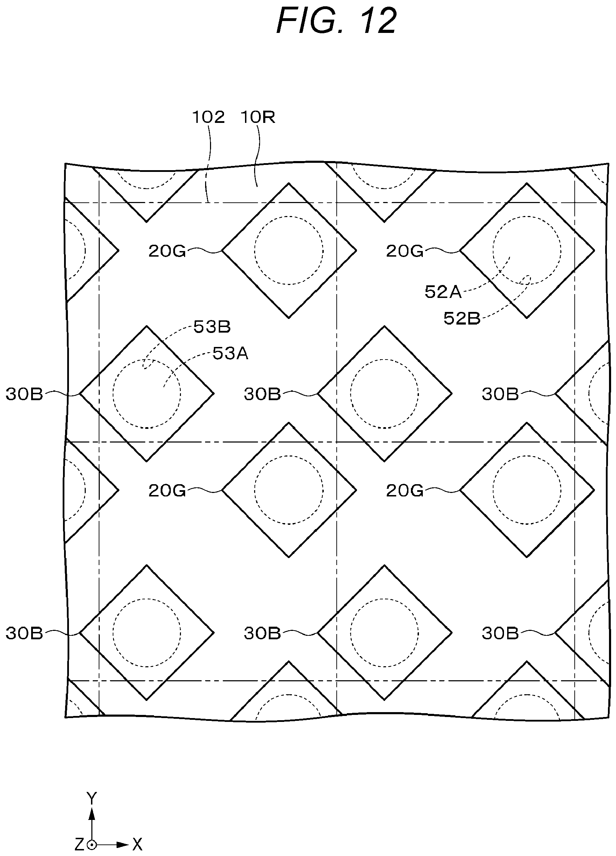

As illustrated in Fig. 12, in a case where the compound semiconductor laminate 11R is connected over the adjacent first light emitting elements 10R, that is, connected over the adjacent pixels 102 without being separated between the adjacent pixels 102, the first light emitting element 10R may have a plurality of holes 52B and a plurality of holes 53B. One hole 52B and one hole 53B are provided for each pixel 102. The hole 52B and the hole 53B penetrate between the first surface and the second surface of the compound semiconductor laminate 11R. The hole 52B is provided for allowing the connection member 52A to pass therethrough. The hole 53B is provided for allowing the connection member 53A to pass therethrough.

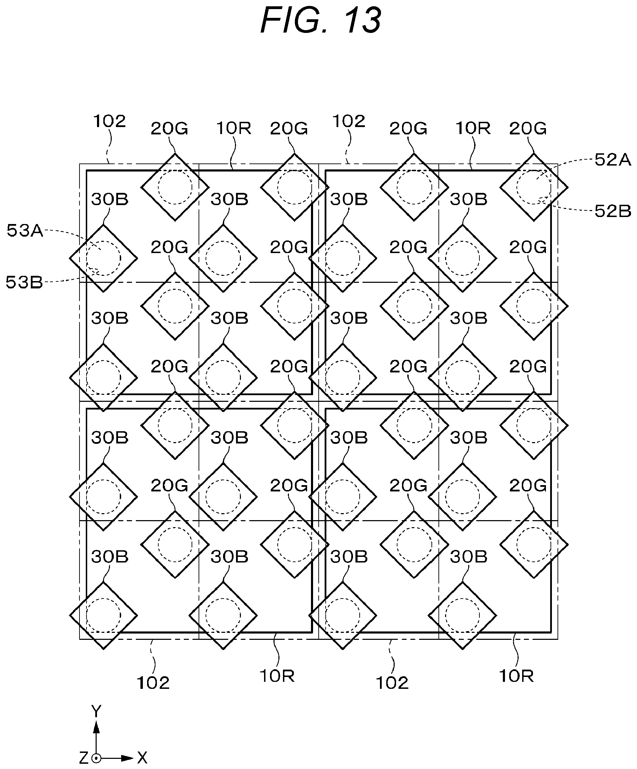

As illustrated in Fig. 13, the compound semiconductor laminate 11R may be divided for every block including a plurality of pixels 102. That is, a block including the plurality of pixels 102 may share one compound semiconductor laminate 11R. Fig. 13 illustrates an example in which the compound semiconductor laminate 11R is divided into every blocks each including four pixels 102. The compound semiconductor laminate 11R may be connected over all the pixels 102 in the display region without being separated between all the pixels 102. That is, all the pixels 102 in the display region may share one compound semiconductor laminate 11R.

In the embodiment, the fourth light emitting element 40R (the compound semiconductor laminate 41R and the electrode 42) may have the similar configuration as that of the first light emitting element 10R (the compound semiconductor laminate 11R and the electrode 12) described above.

### (Modification 4)

In the example, an example in which the first light emitting element 10R has a hexagonal shape and the second light emitting element 20G and the third light emitting element 30B have a quadrangular shape has been described. However, the shapes of the first light emitting element 10R, the second light emitting element 20G, and the third light emitting element 30B are not particularly limited, and can be any shape. For example, the first light emitting element 10R may have a polygonal shape other than a hexagonal shape, and the second light emitting element 20G and the third light emitting element 30B may have a polygonal shape other than a quadrangular shape. The first light emitting element 10R, the second light emitting element 20G, and the third light emitting element 30B may have the same shape.

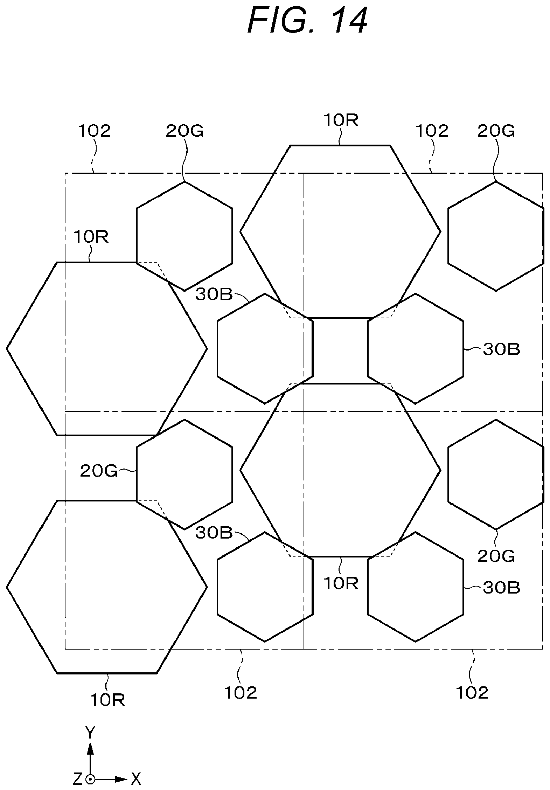

Specifically, for example, as illustrated in Fig. 14, the first light emitting element 10R, the second light emitting element 20G, and the third light emitting element 30B may have a hexagonal shape. The first light emitting element 10R and the second light emitting element 20G may hardly overlap with each other in plan view or may not overlap with each other in plan view. The first light emitting element 10R and the third light emitting element 30B may hardly overlap with each other in plan view or may not overlap with each other in plan view.

Similarly in the embodiment, the shapes of the first light emitting element 10R, the second light emitting element 20G, the third light emitting element 30B, and the fourth light emitting element 40R are not particularly limited, and may be any shape. For example, the fourth light emitting element 40R may have a polygonal shape other than a hexagonal shape.

### (Modification 5)

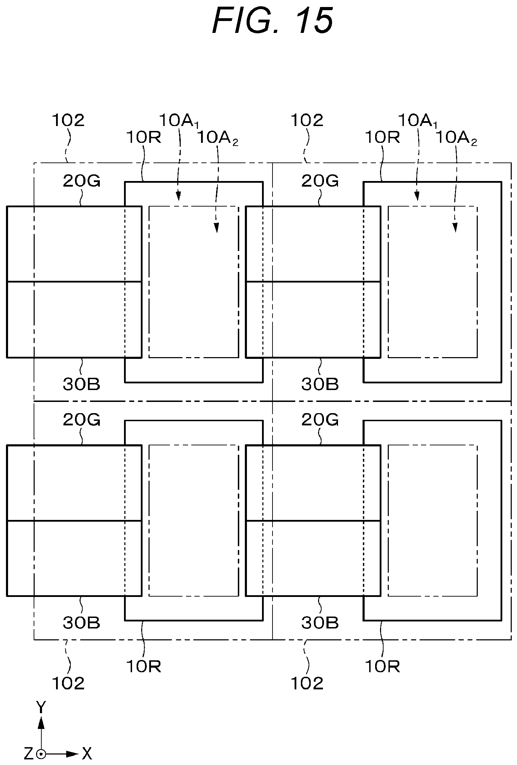

In the example and embodiment, an example has been described in which the second light emitting element 20G (compound semiconductor laminate 21G) and the third light emitting element 30B (compound semiconductor laminate 31B) are separated and configured as separate chips. However, as illustrated in Fig. 15, the second light emitting element 20G (compound semiconductor laminate 21G) and the third light emitting element 30B (compound semiconductor laminate 31B) may be integrated together. Because the second light emitting element 20G (compound semiconductor laminate 21G) and the third light emitting element 30B (compound semiconductor laminate 31B) can include the same based material (for example, AlGaInN-based compound semiconductors having different compositions), an integrated chip can be easily formed.

### (Modification 6)

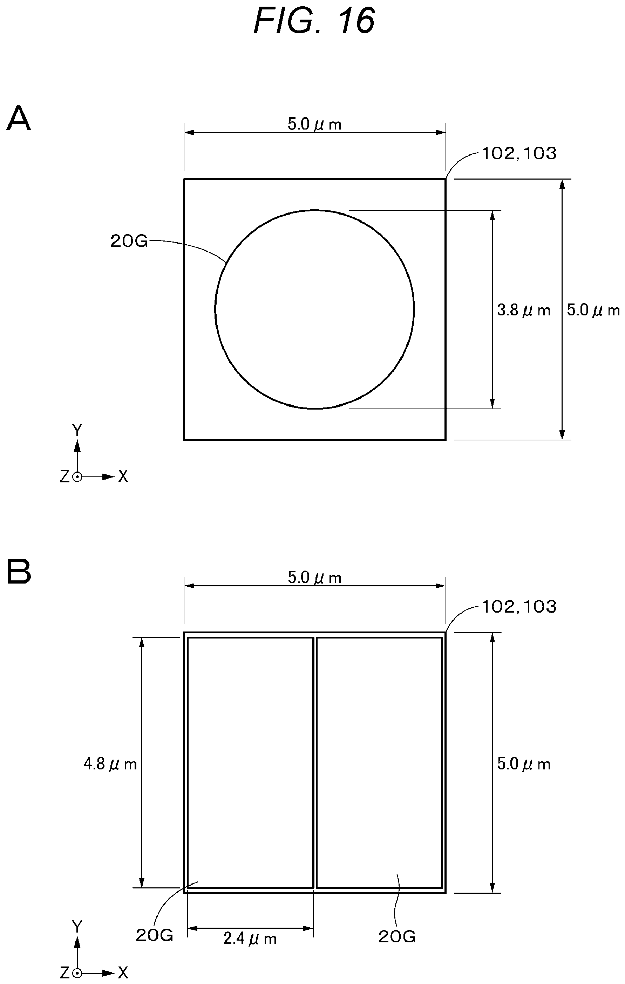

In the example, as illustrated in Fig. 16B, each of the area S_{G} of the second light emitting element 20G and the area S_{B} of the third light emitting element 30B may be smaller than one-half of the area S_{P} of one pixel 102, and the second light emitting element 20G and the third light emitting element 30B may have a shape in which two or more elements can be manufactured from the region 103 of the wafer corresponding to one pixel 102 (a shape in which two or more elements can be embedded in the region 103 of the wafer corresponding to one pixel 102). Similarly in the second embodiment, each of the area S_{G} of the second light emitting element 20G and the area S_{B} of the third light emitting element 30B may be smaller than one-half of the area S_{P} of one pixel 202, and the second light emitting element 20G and the third light emitting element 30B may have a shape in which two or more elements can be manufactured from the region 103 of the wafer corresponding to one pixel 202 (a shape in which two or more elements can be embedded in the region 103 of the wafer corresponding to one pixel 202).

Fig. 16A is a diagram illustrating an example of a shape in which the area S_{G} of the second light emitting element 20G is smaller than one-half of the area S_{P} of one pixel 102, but two or more elements cannot be manufactured from the region 103 of the wafer in which the second light emitting element 20G corresponds to one pixel 102. In this example, the area S_{G} of the second light emitting element 20G is S_{G} = π × (1.9 µm)² = 11.34 µm², and the area S_{P} of one pixel 102 is S_{P} = 5.0 µm × 5.0 µm = 25.0 µm². Therefore, the area S_{G} (= 11.34 µm²) of the second light emitting element 20G satisfies a relationship smaller than 1/2 of the area S_{P} (= 25.0 µm²) of one pixel 102. However, the shape of the second light emitting element 20G is a circular shape in which only one second light emitting element 20G can be manufactured from the region 103 of the wafer corresponding to one pixel 102.

Fig. 16B is a diagram illustrating an example of a shape in which the area S_{G} of the second light emitting element 20G is smaller than one-half of one pixel 102, but two or more elements cannot be manufactured from the region 103 of the wafer in which the second light emitting element 20G corresponds to one pixel 102. In this example, the area S_{G} of the second light emitting element 20G is S_{G} = 2.4 µm × 4.8 µm = 11.52 um², and the area S_{P} of one pixel 102 is S_{P} = 5.0 µm × 5.0 µm = 25.0 µm². Therefore, the area S_{G} (= 11.52 µm²) of the second light emitting element 20G satisfies a relationship smaller than one-half of the area S_{P} (= 25.0 µm²) of one pixel 102. In addition, the shape of the second light emitting element 20G is a rectangular shape in which two second light emitting elements 20G can be manufactured from the region 103 of the wafer corresponding to one pixel 102.

### (Modification 7)

In the example and embodiment, an example has been described in which a portion of the second light emitting element 20G overlaps with the first light emitting element 10R, but the entire second light emitting element 20G may overlap with a region on the outer side of the first light emitting element 10R in plan view. Similarly, the entire third light emitting element 30B may overlap with a region on the outer side of the first light emitting element 10R in plan view. In this case, the influence of the second light emitting element 20G and the third light emitting element 30B on light extraction of the first light emitting element 10R can be suppressed.

In the embodiment, the entire second light emitting element 20G may overlap with a region on the outer side of the fourth light emitting element 40R in plan view. Similarly, the entire third light emitting element 30B may overlap with a region on the outer side of the fourth light emitting element 40R in plan view. In this case, the influence of the second light emitting element 20G and the third light emitting element 30B on light extraction of the fourth light emitting element 40R can be suppressed.

### (Modification 8)

In the example, the display device 100 may further include a plurality of first lenses, a plurality of second lenses, and a plurality of third lenses. The first lens, the second lens, and the third lens are provided above the first light emitting element 10R, the second light emitting element 20G, and the third light emitting element 30B, respectively. In this case, the front luminance of the display device 100 can be improved.

In the embodiment, the display device 200 may further include a plurality of first lenses, a plurality of second lenses, a plurality of third lenses, and a plurality of fourth lenses. The first lens, the second lens, the third lens, and the fourth lens are provided above the first light emitting element 10R, the second light emitting element 20G, the third light emitting element 30B, and the fourth light emitting element 40R, respectively. In this case, the front luminance of the display device 200 can be improved.

### (Modification 9)

In the example, the first light emitting element 10R included in the first layer L1 may have a current confinement structure. With this current confinement structure, a current injection region and a non-current injection region may be formed in the first light emitting element 10R. The non-current injection region may correspond to the non-light emitting/low light emitting region 10A₁, and the current injection region may correspond to the light emitting region 10A₂.

Because the first light emitting element 10R has the current confinement structure, the non-light emitting/low light emitting region 10A₁ can be actively controlled. Therefore, a degree of freedom in the arrangement of the second light emitting element 20G and the third light emitting element 30B included in the second layer L2 can be improved. In a case where the display device 100 includes the second lens and the third lens above the second light emitting element 20G and the third light emitting element 30B, respectively, light control by the second lens and the third lens is facilitated.

In the embodiment, the fourth light emitting element 40R included in the third layer L3 may have a current confinement structure. With this current confinement structure, a current injection region and a non-current injection region may be formed in the fourth light emitting element 40R. The non-current injection region may correspond to the non-light emitting/low light emitting region 40A₁, and the current injection region may correspond to the light emitting region 40A₂.

### (Modification 10)

In the example, an example in which the first light emitting element 10R, the second light emitting element 20G, and the third light emitting element 30B are LED elements has been described, but the first light emitting element 10R, the second light emitting element 20G, and the third light emitting element 30B may be laser diode (LD) elements or super luminescent diode (SLD) elements. Similarly in the second embodiment, the first light emitting element 10R, the second light emitting element 20G, the third light emitting element 30B, and the fourth light emitting element 40R may be LD elements or SLD elements.

### <4 Application example>

### (Electronic apparatus)

The display devices 100 and 200 (hereinafter, referred to as "the display device 100 and the like") according to the first and second embodiments and the modifications thereof described above can be included in various electronic apparatuses. Especially, the display device is preferably provided in an apparatus requiring high resolution of an image and used near the eyes for viewing in a magnified state, the apparatus including an electronic viewfinder of a video camera or a single-lens reflex camera, a head mounted display, or the like.

### (Specific example 1)

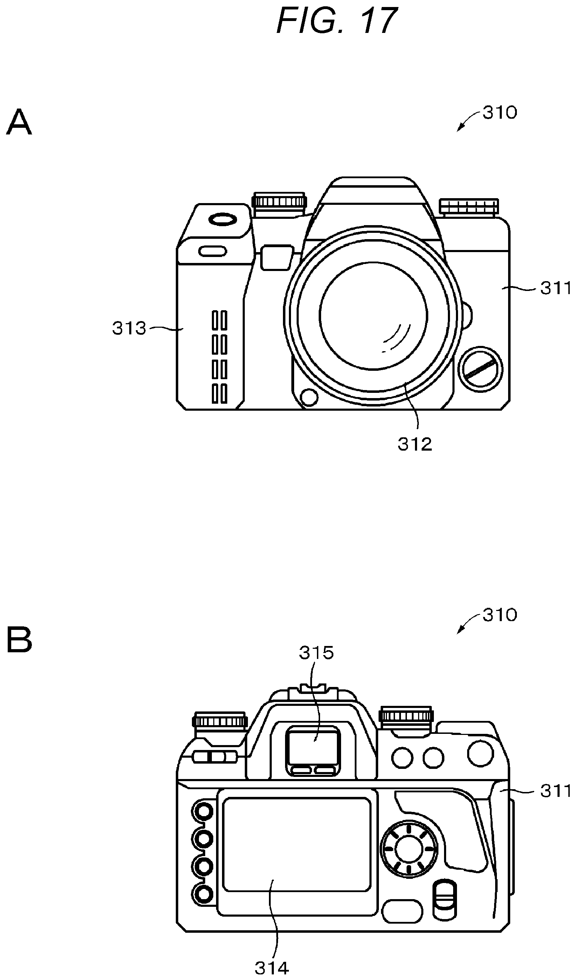

Fig. 17A is a front view illustrating an example of an external appearance of a digital still camera 310. Fig. 17B is a rear view illustrating an example of an external appearance of the digital still camera 310. The digital still camera 310 is of a lens interchangeable single-lens reflex type, and includes an interchangeable imaging lens unit (interchangeable lens) 312 substantially at the center on a front surface of a camera main body (camera body) 311, and a grip 313 to be held by a photographer on a front left side.

A monitor 314 is provided at a position shifted to the left side from the center of a rear surface of the camera main body 311. An electronic viewfinder (eyepiece window) 315 is provided above the monitor 314. By looking through the electronic viewfinder 315, the photographer can visually confirm an optical image of a subject guided from the imaging lens unit 312 and determine a picture composition. The electronic viewfinder 315 includes any of the display device 100 and the like.

### (Specific example 2)

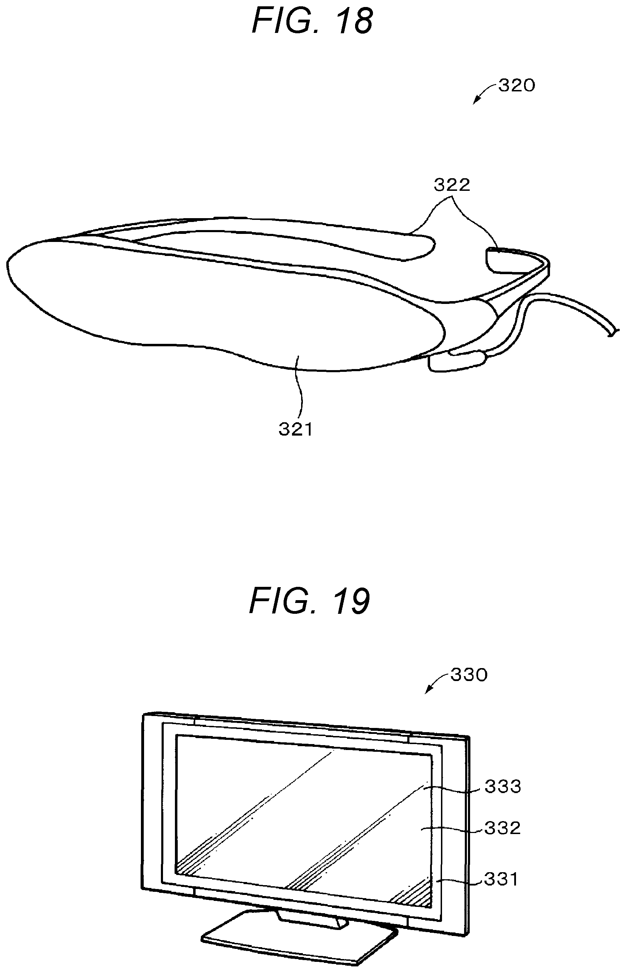

Fig. 18 is a perspective view illustrating an example of an external appearance of a head mounted display 320. The head mounted display 320 includes, for example, ear hooking parts 322 on both sides of a glass-shaped display unit 321, the hooking parts being provided to allow the head mounted display to be worn on the head of the user. The display unit 321 includes any of the display device 100 and the like.

### (Specific example 3)

Fig. 19 is a perspective view illustrating an example of an external appearance of a television apparatus 330. The television apparatus 330 includes, for example, a video display screen unit 331 including a front panel 332 and a filter glass 333, and the video display screen unit 331 includes any of the display device 100 and the like.

Although the embodiment of the present invention and modifications thereof have been specifically described above, the present invention is not limited to the above-described embodiment and modifications thereof, and various modifications based on the technical idea of the present invention within the scope as defined by the claims are possible.

For example, the configurations, methods, steps, shapes, materials, numerical values, and the like mentioned in the above-described first and second embodiments and modifications thereof are merely examples, and configurations, methods, steps, shapes, materials, numerical values, and the like different from these may be used as necessary.

For example, the configurations, methods, steps, shapes, materials, numerical values, and the like of the above-described first and second embodiments and modifications thereof can be combined with each other without departing from the scope of the present invention as defined by the claims.

For example, the materials exemplified in the above-described example and embodiment and modifications thereof can be used alone or in combination of two or more unless otherwise specified.

### REFERENCE SIGNS LIST

10R First compound semiconductor light emitting element
10A₁ Non-light emitting/low light emitting region (first region)
10A₂ Light emitting region (second region)
20G Second compound semiconductor light emitting element
30B Third compound semiconductor light emitting element
40R Fourth compound semiconductor light emitting element
40A₁ Non-light emitting/low light emitting region (third region)
40A₂ Light emitting region (fourth region)
11R, 21G, 31B, 41R Compound semiconductor laminate
12, 22, 32, 42 Electrode
13, 23, 33, 43 Wiring line
13A, 23A, 33A Transparent wiring line
13B, 23B, 33B Metal wiring line
14, 24, 44 Insulating material
51, 52, 53, 54 Pad
51A, 54A Bump
111, 121, 131 First compound semiconductor layer
112, 122, 132 Light emitting layer
113, 123, 133 Second compound semiconductor layer
100, 200 Display device
101, 201 Drive substrate
102, 202 Pixel
102A, 202A Arrow
L1 First layer
L2 Second layer
L3 Third layer
310 Digital still camera (electronic apparatus)
320 Head mounted display (electronic apparatus)
330 Television apparatus (electronic apparatus)

## Claims

1. A light emitting device (200) comprising
a substrate (201), a first layer (L1), and a second layer (L2) in sequence, wherein
the first layer includes a plurality of first semiconductor light emitting elements (10R),
the second layer includes a plurality of second semiconductor light emitting elements (20G),
the plurality of first semiconductor light emitting elements is disposed in an in-plane direction of the substrate, and can emit first light having a first peak wavelength,
each first semiconductor light emitting element has a first region and a second region, the first region is provided in a peripheral edge portion of the first semiconductor light emitting element and cannot emit the first light or can emit only the first light having a lower light emission intensity than the second region, and the second region is provided on an inner side of the first region and can emit the first light, and
the plurality of second semiconductor light emitting elements is disposed in the in-plane direction of the substrate and can emit second light having a second peak wavelength different from the first peak wavelength, and
each first semiconductor light emitting element and each second semiconductor light emitting element are disposed to be shifted from each other in the in-plane direction of the substrate;
wherein the light emitting device comprises a third layer (L3) disposed between the substrate and the first layer,
wherein
the third layer includes a plurality of fourth semiconductor light emitting elements (40R),
the plurality of fourth semiconductor light emitting elements is disposed in the in-plane direction of the substrate, and can emit fourth light having a same color as the first light,
each fourth semiconductor light emitting element has a third region and a fourth region, the third region is provided in a peripheral edge portion of the fourth semiconductor light emitting element and cannot emit the fourth light or can emit only the fourth light having a lower light emission intensity than the fourth region, and the fourth region is provided on an inner side of the third region and can emit the fourth light, and
each first semiconductor light emitting element, each second semiconductor light emitting element, and each fourth semiconductor light emitting element are disposed to be shifted from each other in the in-plane direction of the substrate,
wherein a respective second semiconductor light emitting element overlaps with a part of a respective first semiconductor light emitting element and with a part of a respective fourth semiconductor light emitting element in plan view.

2. The light emitting device according to claim 1, wherein
the second layer further includes a plurality of third semiconductor light emitting elements (30B),
the plurality of third semiconductor light emitting elements is disposed in the in-plane direction of the substrate, and can emit third light having a third peak wavelength different from the first peak wavelength and the second peak wavelength, and
each first semiconductor light emitting element, each second semiconductor light emitting element, each third semiconductor light emitting element, and each fourth semiconductor light emitting element are disposed to be shifted from each other in the in-plane direction of the substrate.

3. The light emitting device according to claim 1, wherein
each first semiconductor light emitting element and
each second semiconductor light emitting element are light emitting diodes.

4. The light emitting device according to claim 2, wherein
the first light is red light or infrared light,
the second light is green light or ultraviolet light, and
the third light is blue light or ultraviolet light.

5. The light emitting device according to claim 1, wherein
each first semiconductor light emitting element includes a compound semiconductor laminate (11R) and an electrode (12), and
the compound semiconductor laminate and the electrode of each first semiconductor light emitting element are separated from the compound semiconductor laminates and the electrodes of adjacent first semiconductor light emitting elements.

6. The light emitting device according to claim 1, wherein
each first semiconductor light emitting element includes an electrode, a first compound semiconductor layer (111), a light emitting layer (112), and a second compound semiconductor layer (113),
the second compound semiconductor layer is connected over the first semiconductor light emitting elements that are adjacent to each other, and
the electrode, the first compound semiconductor layer, and the light emitting layer of each first semiconductor light emitting element are separated from the electrodes, the first compound semiconductor layers, and the light emitting layers of the adjacent first semiconductor light emitting elements.

7. The light emitting device according to claim 1, wherein
each first semiconductor light emitting element includes a compound semiconductor laminate and an electrode,
the compound semiconductor laminate is connected over the first semiconductor light emitting elements that are adjacent to each other, and
the electrode of each first semiconductor light emitting element is separated from the electrodes of the adjacent first semiconductor light emitting elements.

8. The light emitting device according to claim 1, wherein
each second semiconductor light emitting element is positioned on an outer side of the second region in plan view.

9. The light emitting device according to claim 8, wherein
each second semiconductor light emitting element overlaps with a part of the first region in plan view.

10. The light emitting device according to claim 1, further comprising
a connection member (52A) that connects each second semiconductor light emitting element with the substrate, wherein
the connection member is positioned on an outer side of a respective first semiconductor light emitting element in plan view.

11. The light emitting device according to claim 1, wherein
each first semiconductor light emitting element has an area (S_{R}) that is larger than an area (S_{G}) of each second semiconductor light emitting element.

12. An electronic apparatus comprising the light emitting device according to claim 1.

## Patentansprüche

1. Lichtemissionsvorrichtung (200), umfassend
ein Substrat (201), eine erste Schicht (L1) und eine zweite Schicht (L2) in dieser Reihenfolge, wobei
die erste Schicht eine Vielzahl von ersten lichtemittierenden Halbleiterelementen (10R) einschließt,
die zweite Schicht eine Vielzahl von zweiten lichtemittierenden Halbleiterelementen (20G) einschließt,
die Vielzahl von ersten lichtemittierenden Halbleiterelementen in einer Richtung in der Ebene des Substrats angeordnet ist und erstes Licht mit einer ersten Spitzenwellenlänge abgeben kann,
jedes erste lichtemittierende Halbleiterelement einen ersten Bereich und einen zweiten Bereich aufweist, wobei der erste Bereich in einem peripheren Randabschnitt des ersten lichtemittierenden Halbleiterelements bereitgestellt ist und das erste Licht nicht abgeben kann oder nur das erste Licht mit einer geringeren Lichtemissionsintensität als der zweite Bereich abgeben kann, und der zweite Bereich an einer Innenseite des ersten Bereichs bereitgestellt ist und das erste Licht abgeben kann, und
die Vielzahl von zweiten lichtemittierenden Halbleiterelementen in der Richtung in der Ebene des Substrats angeordnet ist und zweites Licht mit einer zweiten Spitzenwellenlänge, die sich von der ersten Spitzenwellenlänge unterscheidet, abgeben kann, und
jedes erste lichtemittierende Halbleiterelement und jedes zweite lichtemittierende Halbleiterelement in der Richtung in der Ebene des Substrats zueinander versetzt angeordnet sind;
wobei die Lichtemissionsvorrichtung eine dritte Schicht (L3) umfasst, die zwischen dem Substrat und der ersten Schicht angeordnet ist, wobei
die dritte Schicht eine Vielzahl von vierten lichtemittierenden Halbleiterelementen (40R) einschließt,
die Vielzahl von vierten lichtemittierenden Halbleiterelementen in der Richtung in der Ebene des Substrats angeordnet ist und viertes Licht mit einer gleichen Farbe wie das erste Licht abgeben kann,
jedes vierte lichtemittierende Halbleiterelement einen dritten Bereich und einen vierten Bereich aufweist, der dritte Bereich in einem peripheren Randabschnitt des vierten lichtemittierenden Halbleiterelements bereitgestellt ist und das vierte Licht nicht abgeben kann oder nur das vierte Licht mit einer geringeren Lichtemissionsintensität als der vierte Bereich abgeben kann, und der vierte Bereich an einer Innenseite des dritten Bereichs bereitgestellt ist und das vierte Licht abgeben kann, und
jedes erste lichtemittierende Halbleiterelement, jedes zweite lichtemittierende Halbleiterelement und jedes vierte lichtemittierende Halbleiterelement in der Richtung in der Ebene des Substrats zueinander versetzt angeordnet sind,
wobei ein jeweiliges zweites lichtemittierendes Halbleiterelement mit einem Teil eines jeweiligen ersten lichtemittierenden Halbleiterelements und mit einem Teil eines jeweiligen vierten lichtemittierenden Halbleiterelements in der Draufsicht überlappt.

2. Lichtemissionsvorrichtung nach Anspruch 1, wobei
die zweite Schicht ferner eine Vielzahl von dritten lichtemittierenden Halbleiterelementen (30B) einschließt,
die Vielzahl von dritten lichtemittierenden Halbleiterelementen in der Richtung in der Ebene des Substrats angeordnet ist und drittes Licht mit einer dritten Spitzenwellenlänge abgeben kann, die sich von der ersten Spitzenwellenlänge und der zweiten Spitzenwellenlänge unterscheidet, und
jedes erste lichtemittierende Halbleiterelement, jedes zweite lichtemittierende Halbleiterelement, jedes dritte lichtemittierende Halbleiterelement und jedes vierte lichtemittierende Halbleiterelement in der Richtung in der Ebene des Substrats zueinander versetzt angeordnet sind.

3. Lichtemissionsvorrichtung nach Anspruch 1, wobei
jedes erste lichtemittierende Halbleiterelement und jedes zweite lichtemittierende Halbleiterelement Leuchtdioden sind.

4. Lichtemissionsvorrichtung nach Anspruch 2, wobei
das erste Licht rotes Licht oder Infrarotlicht ist,
das zweite Licht grünes Licht oder ultraviolettes Licht ist, und
das dritte Licht blaues Licht oder ultraviolettes Licht ist.

5. Lichtemissionsvorrichtung nach Anspruch 1, wobei
jedes erste lichtemittierende Halbleiterelement ein Verbindungshalbleiterlaminat (11R) und eine Elektrode (12) einschließt, und
das Verbindungshalbleiterlaminat und die Elektrode jedes ersten lichtemittierenden Halbleiterelements von den Verbindungshalbleiterlaminaten und den Elektroden benachbarter erster lichtemittierender Halbleiterelemente getrennt sind.

6. Lichtemissionsvorrichtung nach Anspruch 1, wobei
jedes erste lichtemittierende Halbleiterelement eine Elektrode, eine erste Verbindungshalbleiterschicht (111), eine lichtemittierende Schicht (112) und eine zweite Verbindungshalbleiterschicht (113) einschließt,
die zweite Verbindungshalbleiterschicht über die einander benachbarten ersten lichtemittierenden Halbleiterelemente verbunden ist, und
die Elektrode, die erste Verbindungshalbleiterschicht und die lichtemittierende Schicht jedes ersten lichtemittierenden Halbleiterelements von den Elektroden, den ersten Verbindungshalbleiterschichten und den lichtemittierenden Schichten der benachbarten ersten lichtemittierenden Halbleiterelemente getrennt sind.

7. Lichtemissionsvorrichtung nach Anspruch 1, wobei
jedes erste lichtemittierende Halbleiterelement ein Verbindungshalbleiterlaminat und eine Elektrode einschließt,
das Verbindungshalbleiterlaminat über die einander benachbarten ersten lichtemittierenden Halbleiterelemente verbunden ist, und
die Elektrode jedes ersten lichtemittierenden Halbleiterelements von den Elektroden der benachbarten ersten lichtemittierenden Halbleiterelemente getrennt ist.

8. Lichtemissionsvorrichtung nach Anspruch 1, wobei
jedes zweite lichtemittierende Halbleiterelement in der Draufsicht an einer Außenseite des zweiten Bereichs angeordnet ist.

9. Lichtemissionsvorrichtung nach Anspruch 8, wobei
jedes zweite lichtemittierende Halbleiterelement mit einem Teil des ersten Bereichs in der Draufsicht überlappt.

10. Lichtemissionsvorrichtung nach Anspruch 1, ferner umfassend
ein Verbindungselement (52A), das jedes zweite lichtemittierende Halbleiterelement mit dem Substrat verbindet, wobei
das Verbindungselement in der Draufsicht an einer Außenseite eines jeweiligen ersten lichtemittierenden Halbleiterelements angeordnet ist.

11. Lichtemissionsvorrichtung nach Anspruch 1, wobei
jedes erste lichtemittierende Halbleiterelement eine Fläche (S_{R}) aufweist, die größer ist als eine Fläche (S_{G}) jedes zweiten
lichtemittierenden Halbleiterelements.

12. Elektronische Einrichtung, umfassend die Lichtemissionsvorrichtung nach Anspruch 1.

## Revendications

1. Dispositif émetteur de lumière (200) comprenant
un substrat (201), une première couche (L1), et une deuxième couche (L2) en séquence, dans lequel
la première couche comporte une pluralité de premiers éléments émetteurs de lumière à semi-conducteur (10R),
la deuxième couche comporte une pluralité de deuxièmes éléments émetteurs de lumière à semi-conducteur (20G),
la pluralité de premiers éléments émetteurs de lumière à semi-conducteur est disposée dans une direction dans le plan du substrat, et peut émettre de la première lumière ayant une première longueur d'onde de pic,
chaque premier élément émetteur de lumière à semi-conducteur a une première région et une deuxième région, la première région est fournie dans une portion de bord périphérique du premier élément émetteur de lumière à semi-conducteur et ne peut pas émettre la première lumière ou peut émettre uniquement la première lumière ayant une intensité d'émission de lumière plus basse que la deuxième région, et la deuxième région est fournie sur un côté interne de la première région et peut émettre la première lumière, et
la pluralité de deuxièmes éléments émetteurs de lumière à semi-conducteur est disposée dans la direction dans le plan du substrat et peut émettre de la deuxième lumière ayant une deuxième longueur d'onde de pic différente de la première longueur d'onde de pic, et
chaque premier élément émetteur de lumière à semi-conducteur et chaque deuxième élément émetteur de lumière à semi-conducteur sont disposés pour être décalés l'un de l'autre dans la direction dans le plan du substrat ;
dans lequel le dispositif émetteur de lumière comprend une troisième couche (L3) disposée entre le substrat et la première couche, dans lequel
la troisième couche comporte une pluralité de quatrièmes éléments émetteurs de lumière à semi-conducteur (40R),
la pluralité de quatrièmes éléments émetteurs de lumière à semi-conducteur est disposée dans la direction dans le plan du substrat, et peut émettre de la quatrième lumière ayant une même couleur que la première lumière,
chaque quatrième élément émetteur de lumière à semi-conducteur a une troisième région et une quatrième région, la troisième région est fournie dans une portion de bord périphérique du quatrième élément émetteur de lumière à semi-conducteur et ne peut pas émettre la quatrième lumière ou peut émettre uniquement la quatrième lumière ayant une intensité d'émission de lumière plus basse que la quatrième région, et la quatrième région est fournie sur un côté interne de la troisième région et peut émettre la quatrième lumière, et
chaque premier élément émetteur de lumière à semi-conducteur, chaque deuxième élément émetteur de lumière à semi-conducteur et chaque quatrième élément émetteur de lumière à semi-conducteur sont disposés pour être décalés les uns des autres dans la direction dans le plan du substrat,
dans lequel un deuxième élément émetteur de lumière à semi-conducteur respectif chevauche une partie d'un premier élément émetteur de lumière à semi-conducteur respectif et une partie d'un quatrième élément émetteur de lumière à semi-conducteur respectif en vue en plan.

2. Dispositif émetteur de lumière selon la revendication 1, dans lequel
la deuxième couche comporte en outre une pluralité de troisièmes éléments émetteurs de lumière à semi-conducteur (30B),
la pluralité de troisièmes éléments émetteurs de lumière à semi-conducteur est disposée dans la direction dans le plan du substrat, et peut émettre de la troisième lumière ayant une troisième longueur d'onde de pic différente de la première longueur d'onde de pic et de la deuxième longueur d'onde de pic, et
chaque premier élément émetteur de lumière à semi-conducteur, chaque deuxième élément émetteur de lumière à semi-conducteur, chaque troisième élément émetteur de lumière à semi-conducteur et chaque quatrième élément émetteur de lumière à semi-conducteur sont disposés pour être décalés les uns des autres dans la direction dans le plan du substrat.

3. Dispositif émetteur de lumière selon la revendication 1, dans lequel
chaque premier élément émetteur de lumière à semi-conducteur et chaque deuxième élément émetteur de lumière à semi-conducteur sont des diodes électroluminescentes.

4. Dispositif émetteur de lumière selon la revendication 2, dans lequel
la première lumière est de la lumière rouge ou de la lumière infrarouge,
la deuxième lumière est de la lumière verte ou de la lumière ultraviolette, et
la troisième lumière est de la lumière bleue ou de la lumière ultraviolette.

5. Dispositif émetteur de lumière selon la revendication 1, dans lequel
chaque premier élément émetteur de lumière à semi-conducteur comporte un stratifié semi-conducteur composé (11R) et une électrode (12), et
le stratifié semi-conducteur composé et l'électrode de chaque premier élément émetteur de lumière à semi-conducteur sont séparés des stratifiés semiconducteurs composés et des électrodes de premiers éléments émetteurs de lumière à semi-conducteur adjacents.

6. Dispositif émetteur de lumière selon la revendication 1, dans lequel
chaque premier élément émetteur de lumière à semi-conducteur comporte une électrode, une première couche semi-conductrice composée (111), une couche émettrice de lumière (112) et une seconde couche semi-conductrice composée (113),
la seconde couche semi-conductrice composée est connectée sur les premiers éléments émetteurs de lumière à semi-conducteur qui sont adjacents les uns aux autres, et
l'électrode, la première couche semi-conductrice composée et la couche émettrice de lumière de chaque premier élément émetteur de lumière à semi-conducteur sont séparées des électrodes, des premières couches semi-conductrices composées et des couches émettrices de lumière des premiers éléments émetteurs de lumière à semi-conducteur adjacents.

7. Dispositif émetteur de lumière selon la revendication 1, dans lequel
chaque premier élément émetteur de lumière à semi-conducteur comporte un stratifié semi-conducteur composé et une électrode,
le stratifié semi-conducteur composé est connecté sur les premiers éléments émetteurs de lumière à semi-conducteur qui sont adjacents les uns aux autres, et
l'électrode de chaque premier élément émetteur de lumière à semi-conducteur est séparée des électrodes des premiers éléments émetteurs de lumière à semi-conducteur adjacents.

8. Dispositif émetteur de lumière selon la revendication 1, dans lequel
chaque deuxième élément émetteur de lumière à semi-conducteur est positionné sur un côté externe de la deuxième région en vue en plan.

9. Dispositif émetteur de lumière selon la revendication 8, dans lequel
chaque deuxième élément émetteur de lumière à semi-conducteur chevauche une partie de la première région en vue en plan.

10. Dispositif émetteur de lumière selon la revendication 1, comprenant en outre
un élément de connexion (52A) qui connecte chaque deuxième élément émetteur de lumière à semi-conducteur au substrat, dans lequel
l'élément de connexion est positionné sur un côté externe d'un premier élément émetteur de lumière à semi-conducteur respectif en vue en plan.

11. Dispositif émetteur de lumière selon la revendication 1, dans lequel
chaque premier élément émetteur de lumière à semi-conducteur a une aire (S_{R}) qui est plus grande qu'une aire (S_{G}) de chaque deuxième
élément émetteur de lumière à semi-conducteur.

12. Appareil électronique comprenant le dispositif émetteur de lumière selon la revendication 1.
